# EUROPÄISCHE PATENTSCHRIFT

(11) **EP 3 012 858 B1**
(45) Veröffentlichungstag und Bekanntmachung des Hinweises auf die Patenterteilung: **09.08.2017**
(21) Anmeldenummer: 14003620.3
(22) Anmeldetag: 24.10.2014
(51) Int. Cl.: H01L 21/677, H01L 21/67

(54) **Prozesskammeranordnung und Verfahren zum Bestrahlen eines Substrats in einer Prozesskammer**
Process chamber assembly and method for irradiating a substrate in a process chamber
Système de chambre de traitement et procédé de rayonnement d'un substrat dans une chambre de traitement

(43) Veröffentlichungstag der Anmeldung: 27.04.2016
(73) Patentinhaber: Von Ardenne GmbH, 01324 Dresden (DE)
(72) Erfinder: Haasemann, Georg, 01326 Dresden (DE); Khvostikova, Olga, 01159 Dresden (DE)
(74) Vertreter: Viering, Jentschura & Partner mbB Patent- und Rechtsanwälte

(56) Entgegenhaltungen:
- DE-B3-102013 104 577
- JP-A- 2005 026 354
- US-A1- 2009 181 184

## Beschreibung

Die Erfindung betrifft eine Prozesskammeranordnung und ein Verfahren zum Bestrahlen eines Substrats in einer Prozesskammer. Eine verwandte Prozesskammeranordnung ist etwa in US2009181184 A1 gezeigt.

Im Allgemeinen können Substrate, z.B. Platten, Gläser, Wafer, Halbzeuge, Werkzeuge oder andere Verarbeitungsgüter, in einer Prozesskammer bestrahlt werden. Anschaulich kann das Bestrahlen dazu genutzt werden, Energie in das zu bestrahlende Substrat einzutragen. Mittels eines Energieeintrags können beispielsweise chemische Prozesse und/oder physikalische Prozesse in dem Substrat selbst oder in einem Material auf dem Substrat angeregt werden, z.B. eine chemische Reaktion, Diffusion, Kristallwachstum, Ausheilvorgänge im Kristallgitter des Materials oder Ähnliches. Mittels Blitzlampen kann elektromagnetische Strahlung mit vergleichsweise großer Intensität (auch als Flächenleistungsdichte bezeichnet, z.B. mit der Einheit W/cm²) gepulst erzeugt werden, so dass ein Substrat beispielsweise mit einer entsprechend großen Bestrahlungsstärke (auch als Strahlungsstromdichte bezeichnet, z.B. mit der Einheit W/cm²) zeitlich gepulst bestrahlt werden kann. Dabei kann pro Strahlungspuls (auch als Strahlungsblitz bezeichnet) eine definierte Menge an Strahlungsenergie in das Substrat selbst oder in ein Material auf dem Substrat eingebracht werden. Die eingetragene Strahlungsenergie (Strahlungsmenge) pro Fläche wird als Bestrahlung (z.B. mit der Einheit J/cm²) bezeichnet. Die mittels Blitzlampen gepulst erzeugte elektromagnetische Strahlung kann einen Strahlungsanteil im sichtbaren Licht, im infraroten (IR) Bereich und/oder im ultravioletten (UV) Bereich aufweisen. Somit können Blitzlampen beispielsweise für eine UV-Behandlung und/oder eine thermische Behandlung des Verarbeitungsguts verwendet werden.

Gemäß verschiedenen Ausführungsformen werden eine Vorrichtung und ein Verfahren zum Bestrahlen eines Substrats in einer Prozesskammer beschrieben, wobei das Bestrahlen gepulst erfolgen kann. Beispielsweise können mittels einer Blitzlampenanordnung Strahlungspulse erzeugt werden. Ein Strahlungspuls, wie hierin beschrieben, kann mittels des zeitlichen Verlaufs einer physikalischen Größe beschrieben werden, welche den Strahlungspuls charakterisiert, z.B. mittels des zeitlichen Verlaufs der Intensität (in W/m²), der Strahldichte (in W/(m²sr)), der Bestrahlungsstärke (in W/m²), der Bestrahlungsdichte (in W/(cm²sr)), der Strahlungsstärke (in W/sr) oder Ähnlichem. Ein Strahlungspuls, wie hierin beschrieben, kann eine den Strahlungspuls charakterisierende Strahlungspulsdauer aufweisen, wobei die Strahlungspulsdauer, Tp, entsprechend dem zeitlichen Verlauf des Strahlungspulses definiert sein kann. Für einen im zeitlichen Verlauf idealen Rechteckpuls kann die Pulsdauer als Zeitdifferenz aus dem Pulsende und dem Pulsanfang, Tₚ=tₑ-tₐ, definiert sein. Für einen realen Strahlungspuls mit einer maximalen Strahlungspulshöhe kann die Strahlungspulsdauer beispielsweise als die zeitliche Halbwertsbreite des Strahlungspulses definiert sein. Alternativ kann für einen realen Strahlungspuls mit einer maximalen Strahlungspulshöhe ein Schwellwert definiert sein, z.B. als Bruchteil der maximalen Strahlungspulshöhe, z.B. 5%, 10% oder 30%, wobei der Schwellwert den Pulsanfang und das Pulsende des Strahlungspulses definiert, woraus sich die Strahlungspulsdauer des Strahlungspulses ergibt.

Alternativ kann auch der Lampenstrom, I(t), verwendet werden, um den zeitlichen Verlauf des mittels der jeweiligen Blitzlampe erzeugten Strahlungspulses zu charakterisieren, z.B. kann ein Drittel (z.B. ungefähr 33%) des maximalen Lampenstroms, Iₘₐₓ, als Schwellwert verwendet werden, um den Pulsanfang und das Pulsende des Strahlungspulses zu definieren.

Bei elektromagnetischer Strahlung im sichtbaren Wellenlängenbereich (auch bezeichnet als sichtbares Licht) kann das Bestrahlen auch als Belichten bezeichnet werden, sowie die Strahldichte (auch bezeichnet als spezifische Intensität) als Leuchtdichte mit der Einheit W·m⁻² ·sr⁻¹, die Bestrahlungsdichte als Beleuchtungsdichte mit der Einheit W·m⁻²·sr⁻¹, die Strahlungsstärke (auch bezeichnet als Strahlstärke) als Lichtstärke mit der Einheit W·sr⁻¹, die Bestrahlung als Belichtung mit der Einheit J·m⁻², die Strahlungsenergie (auch bezeichnet als Strahlungsmenge) als Lichtmenge mit der Einheit J, die Bestrahlungsstärke (auch bezeichnet als Strahlungsstromdichte) als Beleuchtungsstärke mit der Einheit W·m⁻², der Strahlungsfluss (auch bezeichnet als Strahlungsleistung) als Lichtstrom mit der Einheit W. Falls spektralen Komponenten der elektromagnetischen Strahlung (bzw. des sichtbaren Lichts) bei der Betrachtung berücksichtigt werden, können die zuvor genannten physikalischen Größen als spektrale Größen verwendet werden, z.B. können sich diese ausgehend von der spektralen Strahldichte, L_{Ωλ}(β,ϕ,λ), entsprechend ergeben. Dabei kann die jeweils betrachtete physikalische Größe zum Beschreiben des emittierten Strahlungspulses, mit welchem das Substrat bestrahlt wird, ortsabhängig und/oder zeitabhängig sein. Im Folgenden ist die Ortsabhängigkeit der jeweiligen physikalischen Größe als räumliche Verteilung beschrieben und die Zeitabhängigkeit in dem Begriff Puls verdeutlicht. Bei der Betrachtung der räumlichen Verteilung kann eine Ebene oder Fläche betrachtet werden, welche parallel zu der zu bestrahlenden Oberfläche des Substrats verläuft. Anschaulich kann mittels eines Strahlungspulses, der beispielsweise eine räumliche Verteilung der Intensität und der Bestrahlungsstärke aufweist, eine entsprechende räumliche Verteilung der Bestrahlung in dem Substrat erzeugt werden. Die effektiv in einen Bereich des Substrats eingetragene Energie kann auch von den Absorptionseigenschaften des Materials in diesem Bereich des Substrats beeinflusst werden.

Im Folgenden bezeichnet der Ausdruck "Bestrahlung" die physikalische Größe Bestrahlung mit dem Formelzeichen H und mit der Einheit J·m⁻² bzw. J·cm⁻², beispielsweise für einen gegebenen Ort die eingestrahlte Strahlungsenergie Q pro Fläche oder das Integral der Bestrahlungsstärke E in W·m⁻² über eine vordefinierte Zeitdauer (z.B. über die Strahlungspulsdauer oder über die Zeitdauer des jeweiligen Bestrahlens).

Der Strahlungspuls kann beispielsweise einen derartigen zeitlichen Verlauf aufweisen, dass kein stationärer Wert, z.B. für die Intensität bzw. die Bestrahlungsstärke, erreicht wird. Somit kann beispielsweise eine Charakterisierung des Strahlungspulses auf Basis einer durchschnittlichen Leistung und der entsprechenden Pulsdauer erfolgen oder auf Basis eines maximalen Werts und einer bekannten Form des Strahlungspulses, da sich die momentane Leistung während des Pulses verändern kann. Somit kann es beispielsweise günstig sein, die Bestrahlung im Zusammenhang mit der Pulsdauer zu verwenden, um den Strahlungspuls zu charakterisieren. Ferner kann auch der Lampenstrom genutzt werden, um den Strahlungspuls zu charakterisieren. Aufgrund der Ortsabhängigkeit des Strahlungspulses kann die Substratebene als Referenzebene verwendet werden, da eine definierte Bestrahlung des Substrats angestrebt sein kann.

Das Bestrahlen des Substrats kann beispielsweise in einer Prozesskammer (auch als Bestrahlungskammer bezeichnet) oder in mehreren Prozesskammern einer Prozessieranlage erfolgen, z.B. im Vakuum (z.B. bei einem Druck von weniger als 100 mbar), bei Normaldruck bzw. Atmosphärendruck (z.B. bei einem Druck von ungefähr 1 bar) oder bei Überdruck (z.B. bei einem Druck von mehr als ungefähr 1 bar). Das Bestrahlen kann mittels einer Blitzlampe oder mittels mehrerer Blitzlampen erfolgen. Beispielsweise kann mittels einer Blitzlampe oder mittels mehrerer Blitzlampen eine RTP-Behandlung (ein sogenanntes Rapid-Thermal-Processing oder Kurzzeittempern) des Substrats selbst oder eine RTP-Behandlung einer Beschichtung des Substrats erfolgen.

Herkömmlicherweise werden beispielsweise Wafer mittels Blitzlampen derart bestrahlt, dass der gesamte Wafer gleichzeitig bestrahlt wird, um eine flächig homogene Bestrahlung des Wafers zu erreichen. Dazu kann herkömmlicherweise mittels mehrerer Blitzlampen ein Bestrahlungsbereich erzeugt werden, welcher es ermöglicht, die gesamte Oberfläche des Wafers gleichzeitig in dem Bestrahlungsbereich zu bestrahlen. Anschaulich kann es bei einigen Bestrahlungsprozessen (Belichtungsprozessen) schwierig sein, eine Oberfläche eines Substrats homogen zu bestrahlen (bzw. zu belichten), wenn die Oberfläche des Substrats nicht vollständig in den Bestrahlungsbereich hinein passt und somit die Oberfläche des Substrats abschnittsweise (sequenziell) bestrahlt werden muss. Allerdings kann es aus konstruktiven Gründen beispielsweise für große Substrate (z.B. mit einer Oberfläche von mehr als 1 m², mehr als 2 m², mehr als 5 m² oder sogar mehr als 10 m²) unmöglich sein, den Bestrahlungsbereich derart groß zu gestalten, dass derart große Substrate vollständig in den Bestrahlungsbereich hinein passen. Dies kann beispielsweise dann schwierig sein, wenn derart große Substrate mit einer großen Bestrahlungsstärke oder mit einer großen Bestrahlung bestrahlt werden sollen, z.B. mit mehr als 10 W/mm² bzw. mehr als 1 J/cm², mit mehr als 100 W/mm² bzw. mehr als 10 J/cm², mit mehr als 50 W/mm² bzw. mehr als 1 J/cm² oder mit mehr als 500 W/mm² bzw. mehr als 10 J/cm².

Die hierin beschriebene Leistungsdichte (die Bestrahlungsstärke) kann beispielsweise zeitlich gemittelt sein. Beispielsweise kann ein Bestrahlungspuls eine vordefinierte Pulsdauer aufweisen, z.B. 300 µs, und aus der Energiedichte (der Bestrahlung) in der Substratebene und der Pulsdauer kann sich eine mittlere Leistungsdichte ergeben.

Anschaulich kann das möglichst homogene Bestrahlen von Flächen mit zunehmend großer Bestrahlungsfläche sehr viel schwieriger werden. Es kann beispielsweise nicht eindeutig sein, ob oder wie Prozesse von kleinen Anlagen (z.B. zum Bestrahlen kleiner Substrate mit einer Fläche von weniger als 1 m²) skaliert werden können. Gemäß verschiedenen Ausführungsformen können mehrere Blitzlampen (z.B. mehrere als Blitzlampen betriebene Gasentladungsröhren), z.B. zwei, drei, vier, fünf, sechs, sieben, acht, neun oder zehn Blitzlampen oder mehr als zehn Blitzlampen genutzt werden, um ein Substrat abschnittsweise in einem Bestrahlungsbereich zu bestrahlen, wobei die Blitzlampen jeweils eine Länge von mehr als 1 m aufweisen, z.B. eine Länge in einem Bereich von ungefähr 1 m bis ungefähr 5 m. Dabei kann der Bestrahlungsbereich mittels einer Blendenanordnung (auch bezeichnet als Reflektoranordnung) begrenzt sein, wobei die Blendenanordnung die Blitzlampen zumindest teilweise umgibt. Die Gasentladungsröhren (bzw. Blitzlampen) können achsparallel nebeneinander angeordnet sein und anschaulich ein Blitzlampenfeld bereitstellen. Ferner können die Gasentladungsröhren (bzw. Blitzlampen) als ein Blitzlampenmodul bereitgestellt sein oder werden, welches mit einer Prozesskammer gekoppelt werden kann zum Bestrahlen eines Substrats in der Prozesskammer.

Gemäß verschiedenen Ausführungsformen kann eine Prozesskammeranordnung (auch als Prozessieranordnung oder Prozessieranlage bezeichnet), wie hierin beschrieben, eine Prozesskammer (z.B. eine Vakuumkammer) oder mehrere Prozesskammern (z.B. mehrere Vakuumkammern) aufweisen, wobei die Prozesskammer bzw. mindestens eine der Prozesskammern als Bestrahlungskammer (Belichtungskammer) eingerichtet sein kann. Beispielsweise kann die Prozesskammeranordnung als eine so genannte Batch-Prozessieranlage eingerichtet sein, in welcher beispielsweise plattenförmige Substrate nacheinander schubweise prozessiert werden können. Ferner kann die Prozesskammeranordnung als eine so genannte In-Line-Prozessieranlage eingerichtet sein, wobei beispielsweise plattenförmige Substrate (z.B. kontinuierlich als so genanntes Endlossubstrat oder Substratband) kontinuierlich auf einem Transportsystem durch mehrere Prozesskammern (auch als Kompartments bezeichnet) hindurch geführt werden können. Dabei kann ein plattenförmiges Substrat (oder ein beliebiges anderes Verarbeitungsgut) mittels mindestens einer Schleusenkammer in die Prozesskammeranordnung eingebracht und/oder aus der Prozesskammeranordnung heraus gebracht werden. Ferner kann die Prozesskammeranordnung als eine so genannte Luft-zu-Luft (Air-to-Air) Prozessieranlage eingerichtet sein. Ferner kann die Prozesskammeranordnung als eine Band-Prozessieranlage, wobei ein Bandsubstrat (z.B. ein Blech oder eine Folie) beispielsweise von Rolle-zu-Rolle durch mindestens eine Prozesskammer der Prozesskammeranordnung hindurch transportiert werden kann.

Ein Endlossubstrat kann beispielsweise mehrere nacheinander (hintereinander) transportierte Substrate aufweisen, welche beispielsweise derart zusammengeführt wurden, dass zwischen zwei aufeinanderfolgenden Substraten nur ein geringer Spalt bereitgestellt ist. Dabei können die Substrate beispielsweise Glasplatten oder Glassubstrate sein, oder beliebige andere geeignete Substrate, wie beispielsweise Halbleitersubstrate. Das Zusammenfügen mehrerer plattenförmiger Substrate zu einem Endlossubstrat oder das Vereinzeln eines Endlossubstrats in mehrere einzelne Substrate, z.B. zum schubweisen Einschleusen und/oder schubweisen Ausschleusen der Substrate aus der Prozesskammeranordnung, kann mittels einer so genannten Transferkammer erfolgen. Eine Transferkammer kann ein Transportsystem aufweisen, welches derart eingerichtet ist, dass die Substrate zu einem Endlossubstrat zusammengefügt werden, wobei sich alle Substrate des Endlossubstrats mit gleicher Transportgeschwindigkeit bewegen. Anschaulich können die Transportrollen der Transferkammer mittels einer Antriebssteuerung oder Antriebsregelung entsprechend angetrieben werden.

Gemäß verschiedenen Ausführungsformen wird eine Prozessieranlage bereitgestellt, mittels derer ein Bandsubstrat (z.B. ein Metallband oder eine Folie), ein Endlossubstrat (z.B. mehrere plattenförmige Substrate) oder ein großflächiges Substrat prozessiert werden kann, wobei das prozessierte Substrat beispielsweise in einem gepulsten Bestrahlungsprozess (z.B. unter Verwendung von Blitzlampen) abschnittsweise (sequentiell) bestrahlt wird. Ziel eines Bestrahlungsprozesses (Belichtungsprozesses) kann es beispielsweise sein, das Substrat oder eine Beschichtung des Substrats mittels des Bestrahlens zu verändern, wobei über die gesamte Oberfläche des Substrats die gleiche Veränderung erzeugt werden sollen. Anschaulich soll mittels eines sequentiellen (nacheinander durchgeführten) abschnittsweisen Bestrahlens mehrerer Teiloberflächen einer Oberfläche das gleiche Resultat erreicht werden, als wäre die gesamte Oberfläche, als Vereinigung der mehreren Teiloberflächen, gleichzeitig, z.B. mittels nur eines Bestrahlens, bestrahlt worden.

Beispielsweise kann ein Substrat (z.B. ein optisch zumindest teilweise transparentes Substrat, wie beispielsweise eine Glasscheibe) eine Beschichtung aufweisen, welche die Absorptions-, Transmissions- und Emissionscharakteristik des Substrats verändert. Beispielsweise kann eine Metallbeschichtung (z.B. aufweisend Titan, Edelstahl, Chrom, Silber und/oder Gold) auf einer Glasscheibe als Sonnenschutzbeschichtung und/oder als Wärmeschutzbeschichtung verwendet werden. Mittels einer Silberschicht als Infrarotreflektor kann beispielsweise eine so genannte niedrigemittierende (low-E) Beschichtung bereitgestellt werden, welche die Emissionscharakteristik der Glasscheibe im infraroten Bereich des elektromagnetischen Wellenlängenspektrums verändert, beispielsweise den Emissionskoeffizienten im infraroten Bereich des elektromagnetischen Wellenlängenspektrums reduziert, wobei die optischen Eigenschaften im Wellenlängenbereich des sichtbaren Lichts den Einsatz als Architekturglas ermöglichen.

Ein Substrat kann beispielsweise eine Beschichtung (z.B. eine low-E Beschichtung) mit einer Vielzahl von Schichten in Form eines Schichtstapels aufweisen, z.B. eine oder mehrere metallische Schichten, z.B. aufweisend Chrom, Titan, Silber und/oder Gold als Reflexionsschichten, eine oder mehrere dielektrische Schichten, z.B. aufweisend Siliziumnitrid und/oder Zinnoxid als Schutzschichten bzw. Deckschichten, z.B. aufweisend Titanoxid, Bismutoxid und/oder Zinnoxid als Interferenzschichten. Ferner kann eine Beschichtung eine oder mehrere Metallschichten oder Metalllegierungsschichten aufweisen, z.B. aufweisend Nickel/Chrom und/oder Ti als Pufferschichten oder Diffusionsbarrieren. Ferner kann eine Beschichtung eine oder mehrere Oxidschichten aufweisen, z.B. eine Zinkoxidschicht als Keimschicht (auch Saatschicht genannt).

Die optischen und/oder elektrischen Eigenschaften einer dünnen abgeschiedenen Metallschicht, z.B. einer auf einem Glassubstrat abgeschiedenen dünnen Silberschicht (z.B. mit einer Schichtdicke in einem Bereich von ungefähr 1 nm bis ungefähr 100 nm), können mittels eines RTP-Verfahrens (so genanntem Kurzzeittempern) beeinflusst werden, z.B. kann der elektrische Widerstand (der Flächenwiderstand) verringert werden und/oder die Reflektivität im infraroten Wellenlängenbereich des Lichts erhöht werden.

Ferner kann eine Beschichtung ein transparentes, elektrisch leitfähiges Oxid aufweisen. Transparente, elektrisch leitfähige Oxide (auch als TCOs bezeichnet, engl. transparent conducting oxides) können für elektromagnetische Strahlung im Wellenlängenbereich des sichtbaren Lichts im Wesentlichen transparent sein und gleichzeitig elektrisch leitfähig sein. Als transparente, elektrisch leitfähige Oxide können beispielsweise Aluminium-Zink-Oxid (AZO, Aluminium-dotiertes Zink-Oxid), Indium-Zinn-Oxid (ITO), Fluor-Zinn-Oxid (FTO), und/oder Antimon-Zinn-Oxid (ATO) verwendet werden. Die optischen und/oder elektrischen Eigenschaften einer abgeschiedenen TCO-Schicht, z.B. einer auf einem Substrat abgeschiedenen ITO-Schicht, können mittels eines RTP-Verfahrens beeinflusst werden, z.B. kann der elektrische Widerstand (der Flächenwiderstand) der TCO-Schicht verringert werden, die Transmissivität (z.B. im Wellenlängenbereich des sichtbaren Lichts) der TCO-Schicht erhöht werden (oder die Transmissivität kann bei einer Reduzierung des elektrischen Widerstands der TCO-Schicht zumindest unbeeinflusst bleiben), oder z.B. kann die Oberflächenrauheit (die RMS-Rauheit, auch genannt quadratische Rauheit; RMS engl. root-mean-squared) der TCO-Schicht verringert werden.

Das Bestrahlen eines Substrats oder einer Beschichtung auf einem Substrat kann die chemischen Eigenschaften (z.B. die chemische Zusammensetzung, die chemischen Phasen und/oder die chemischen Bindungsverhältnisse) und/oder die physikalischen Eigenschaften (z.B. elektronische Eigenschaften, optische Eigenschaften und/oder die Mikrostruktur) beeinflussen, wobei Strahlung mit ausreichend hoher Intensität (z.B. mehr als 100 W/cm²) auf großen Flächen (z.B. auf Flächen größer als 1 m²) mittels Blitzlampen erzeugt werden kann.

Eine Gasentladungsröhre kann derart betrieben werden, dass diese einen Strahlungspuls, auch bezeichnet als Strahlungsblitz oder Strahlungsimpuls (bzw. Lichtpuls, Lichtblitz oder Lichtimpuls) aussendet. Anschaulich kann elektromagnetische Strahlung, welche als Strahlungspuls mit einer Pulsdauer von weniger als 100 ms emittiert wird, als Strahlungsblitz (bzw. Lichtblitz) bezeichnet werden. Dazu kann beispielsweise ein Treiberschaltkreis für die Gasentladungsröhre derart bereitgestellt sein oder werden, das beispielsweise ein Kondensator (oder ein anderer Energiespeicher) mittels der Gasentladungsröhre entladen werden kann. Der Treiberschaltkreis und die Gasentladungsröhre können dabei die Entladungscharakteristik definieren und somit beispielsweise auch die Pulsdauer des erzeugten Strahlungspulses, den zeitlichen Verlauf (anschaulich die Form) des erzeugten Strahlungspulses, und/oder die maximale Höhe des erzeugten Strahlungspulses. Ferner kann das verwendete Gas in der Gasentladungsröhre, z.B. die chemische Zusammensetzungen des Gases und/oder der Gasdruck, die maximale Höhe des erzeugten Strahlungspulses und/oder das Wellenlängenspektrum des erzeugten Strahlungspulses definieren. Als physikalische Größen für beispielsweise die Form, die Dauer und die Höhe des erzeugten Strahlungspulses kann die Intensität (als physikalisch definierte Flächenleistungsdichte) oder auch eine radiometrische Größe zur Beschreibung der Strahlung verwendet werden.

Gemäß verschiedenen Ausführungsformen kann ein Verfahren zum Bestrahlen eines Substrats in einer Prozesskammer Folgendes aufweisen: Transportieren des Substrats entlang einer Transportrichtung in einem Bestrahlungsbereich in der Prozesskammer, wobei der Bestrahlungsbereich mittels einer Blendenstruktur auf eine Bestrahlungsbereichslänge, L, in Transportrichtung begrenzt ist; wobei die Bestrahlungsbereichslänge kleiner ist als eine Substratlänge des Substrats in Transportrichtung; und ein erstes Bestrahlen des Substrats in dem Bestrahlungsbereich und danach ein zweites Bestrahlen des Substrats in dem Bestrahlungsbereich, während das Substrat mit einer Transportgeschwindigkeit, V, transportiert wird, wobei der zeitliche Abstand des ersten Bestrahlens und des zweiten Bestrahlens (voneinander) größer als L/(2V) ist, so dass mindestens ein erster Bereich des Substrats genau einmal bestrahlt wird, und kleiner als L/V ist, so dass mindestens ein zweiter Bereich des Substrats genau zweimal bestrahlt wird.

Gemäß verschiedenen Ausführungsformen kann das Substrat ein plattenförmiges Substrat sein, ein Bandsubstrat (z.B. ein Metallband, eine Metallfolie oder eine Polymerfolie) oder ein aus einer Vielzahl von Substraten gebildetes Endlossubstrat bzw. Substratband. Bei einem Endlossubstrat kann die jeweilige Länge der einzelnen Substrate in Transportrichtung auch kleiner sein als die Bestrahlungsbereichslänge, wobei die Substratlänge, welche von dem Endlossubstrat definiert ist, größer als die Bestrahlungsbereichslänge ist. Anschaulich kann bei einem Endlossubstrat die Länge der einzelnen Substrate unwesentlich sein, da bei dem Endlossubstrat die aneinandergereiht transportierten mehreren Substrate in deren Gesamtheit wesentlich sind. Ferner kann ein Substrat eine Beschichtung aufweisen, wobei dann beim Bestrahlen des Substrats die Beschichtung bestrahlt wird.

Ferner kann der Substrattransport kontinuierlich, z.B. mit konstanter Geschwindigkeit, erfolgen, wobei das Bestrahlen des Substrats periodisch erfolgen kann. Dazu kann der zeitliche Abstand zwischen dem ersten Bestrahlen und dem zweiten Bestrahlen eine Periodendauer bzw. eine Frequenz definieren, mit der das Substrat bestrahlt wird.

Anschaulich kann somit die gesamte zu bestrahlende Fläche des Substrats abschnittsweise (sequentiell) bestrahlt werden, wobei beispielsweise kein Abschnitt der zu bestrahlenden Fläche mehr als zweimal mittels des ersten Bestrahlens und des zweiten Bestrahlens (oder mittels des periodischen Bestrahlens) bestrahlt wird. Ferner kann die gesamte zu bestrahlende Fläche des Substrats abschnittsweise (sequentiell) bestrahlt werden, wobei in dem gesamten Bestrahlungsprozess kein Abschnitt der zu bestrahlenden Fläche mehr als zweimal bestrahlt wird.

Gemäß verschiedenen Ausführungsformen können das erste Bestrahlen und das zweite Bestrahlen des Substrats in dem Bestrahlungsbereich jeweils mittels mindestens eines Strahlungspulses erfolgen, wobei der jeweilige mindestens eine Strahlungspuls in dem Bestrahlungsbereich eine räumliche Strahlungsverteilung (z.B. räumliche Strahldichteverteilung, räumliche Intensitätsverteilung, räumliche Bestrahlungsstärkenverteilung, oder räumliche Bestrahlungsverteilung, oder Ähnliches) entlang der Transportrichtung aufweist.

Gemäß verschiedenen Ausführungsformen können das erste Bestrahlen und das zweite Bestrahlen unter Verwendung einer Blitzlampenanordnung erfolgen, wobei die Blitzlampenanordnung mindestens eine Gasentladungsröhre aufweist, wobei sich die mindestens eine Gasentladungsröhre quer zur Transportrichtung erstreckt. Mit anderen Worten kann die mindestens eine Gasentladungsröhre zylinderförmig sein und die Zylinderachse kann quer zur Transportrichtung ausgerichtet sein.

Alternativ kann die Blitzlampenanordnung mindestens eine Gasentladungsröhre aufweisen, wobei sich die mindestens eine Gasentladungsröhre in Substrattransportrichtung erstreckt, d.h. im Wesentlichen parallel zur Substrattransportrichtung angeordnet ist. Anschaulich kann die Blitzlampenanordnung derart bereitgestellt sein oder werden, dass eine möglichst räumlich homogene Bestrahlung des Substrats erfolgen kann.

Mit anderen Worten kann das erste Bestrahlen des Substrats in dem Bestrahlungsbereich mittels mindestens eines ersten Strahlungspulses erfolgen, wobei der mindestens eine erste Strahlungspuls in dem Bestrahlungsbereich eine erste räumliche Strahlungsverteilung entlang der Transportrichtung aufweist; und ferner kann das zweite Bestrahlen des Substrats in dem Bestrahlungsbereich mittels mindestens eines zweiten Strahlungspulses erfolgen, wobei der mindestens eine zweite Strahlungspuls in dem Bestrahlungsbereich eine zweite räumliche Strahlungsverteilung entlang der Transportrichtung aufweist. Dabei können die erste räumliche Strahlungsverteilung und die zweite räumliche Strahlungsverteilung im Wesentlichen gleich sein. Ferner kann der mindestens eine erste Strahlungspuls mittels einer Blitzlampenanordnung erzeugt werden und der mindesten eine zweite Strahlungspuls kann mittels derselben Blitzlampenanordnung erzeugt werden.

Gemäß verschiedenen Ausführungsformen kann die Blitzlampenanordnung mindestens einen Treibschaltkreis aufweisen zum Betreiben der mindestens einen Gasentladungsröhre als Blitzlampe.

Gemäß verschiedenen Ausführungsformen können das erste Bestrahlen und das zweite Bestrahlen des Substrats in dem Bestrahlungsbereich jeweils mittels genau eines Strahlungspulses pro betriebene Gasentladungsröhre erfolgen. Anschaulich können mehrere Gasentladungsröhre synchron gezündet werden, so dass sich die mehreren Strahlungspulse zu einem gemeinsamen Strahlungspuls überlagern können, wobei dann das erste Bestrahlen und das zweite Bestrahlen des Substrats jeweils mittels genau eines derartigen gemeinsamen Strahlungspulses erfolgen kann.

Anschaulich können mehrere Strahlungspulse in einem kurzen Zeitabstand zueinander das jeweilige Bestrahlen ermöglichen, wobei die mehreren Strahlungspulse innerhalb von 100 ms erfolgen können, z.B. innerhalb von 50 ms, innerhalb von 20 ms, innerhalb von 10 ms, oder innerhalb von 1 ms. Mit anderen Worten kann das Bestrahlen (z.B. das erste Bestrahlen bzw. das zweite Bestrahlen) innerhalb einer Zeitdauer (bzw. innerhalb eines Zeitintervalls) von weniger als 0,1 s erfolgen, z.B. innerhalb von weniger als 0,05 s, innerhalb von weniger als 0,02 s, innerhalb von weniger als 0,01 s, oder innerhalb von weniger als 0,001 s. Dabei kann sich die Zeitdauer des Bestrahlens aus der Pulsdauer der einzelnen Strahlungspulse sowie dem zeitlichen Versatz der einzelnen Strahlungspulse zueinander definieren. Dabei kann der zeitliche Versatz der einzelnen Strahlungspulse zueinander möglichst klein sein, so dass beispielsweise die Zeitdauer des Bestrahlens nicht länger als das zweifache der Pulsdauer der einzelnen Strahlungspulse ist. In diesem Zeitbereich kann das Substrat näherungsweise als ruhend betrachtet werden.

Dagegen kann der zeitliche Abstand zwischen dem jeweiligen Bestrahlen (z.B. zwischen dem ersten Bestrahlen und dem zweiten Bestrahlen) vergleichsweise groß sein, z.B. mehr als 0,1 s, mehr als 0,5 s, mehr als 1 s, mehr als 2 s, mehr als 3 s, mehr als 4 s, mehr als 5 s, mehr als 6 s, mehr als 7 s, mehr als 8 s, mehr als 9 s, mehr als 10 s, mehr als 20 s, mehr als 30 s, mehr als 40 s, mehr als 50 s, oder mehr als 60 s. Der zeitliche Abstand zwischen dem jeweiligen Bestrahlen kann beispielsweise u.a. basierend auf der Substratgeschwindigkeit definiert sein oder werden.

Der zeitliche Abstand des erstens Bestrahlens und des zweiten Bestrahlens kann als Zeitabstand definiert sein, welcher vom Anfang des ersten Bestrahlens bis zum Anfang des zweiten Bestrahlens gemessen wird. Ferner kann der Zeitabstand des erstens Bestrahlens und des zweiten Bestrahlens als Zeitabstand definiert sein, welcher vom Ende des ersten Bestrahlens und bis zum Ende des zweiten Bestrahlens gemessen wird. Ferner kann der zeitliche Abstand des erstens Bestrahlens und des zweiten Bestrahlens als Periodendauer (und somit auch als Frequenz) verstanden werden, wenn das Bestrahlen zeitlich periodisch erfolgt. Die Periodendauer (bzw. die Frequenz) eines zeitlich periodischen Bestrahlens kann beispielsweise in einem Bereich von ungefähr 0,1 s (bzw. 10 Hz) bis ungefähr 300 s (bzw. 1/300 Hz) liegen, z.B. in einem Bereich von ungefähr 0,5 s (bzw. 2 Hz) bis ungefähr 300 s (bzw. 1/300 Hz), z.B. in einem Bereich von ungefähr 1 s (bzw. 1/6 Hz) bis ungefähr 200 s (bzw. 1/200 Hz), z.B. in einem Bereich von ungefähr 0,5 s (bzw. 2 Hz) bis ungefähr 10 s (bzw. 1/10 Hz).

Ferner kann der Bestrahlungsbereich mittels einer Blendenstruktur auf eine Bestrahlungsbereichslänge, L, in Transportrichtung in einem Bereich von ungefähr 20 cm bis ungefähr 600 cm begrenzt sein oder werden, z.B. auf eine Bestrahlungsbereichslänge in einem Bereich von ungefähr 20 cm bis ungefähr 300 cm, z.B. in einem Bereich von ungefähr 20 cm bis ungefähr 200 cm, z.B. in einem Bereich von ungefähr 20 cm bis ungefähr 100 cm, z.B. in einem Bereich von ungefähr 30 cm bis ungefähr 70 cm, z.B. in einem Bereich von ungefähr 30 cm bis ungefähr 60 cm, z.B. in einem Bereich von ungefähr 20 cm bis ungefähr 50 cm, z.B. in einem Bereich von ungefähr 20 cm bis ungefähr 40 cm.

Gemäß verschiedenen Ausführungsformen kann ein Bestrahlen als ein Vorgang verstanden werden, welcher die Eigenschaften des bestrahlten Substrats beeinflusst, d.h. anschaulich eine ausreichend hohe Bestrahlung des Substrats erzeugt (z.B. gemittelt über die gesamte bestrahlte Fläche), z.B. eine Bestrahlung von mehr als 0,1 J/cm², z.B. eine Bestrahlung von mehr als 0,2 J/cm², z.B. eine Bestrahlung von mehr als 0,3 J/cm², z.B. eine Bestrahlung von mehr als 0,4 J/cm², z.B. eine Bestrahlung von mehr als 0,5 J/cm², z.B. eine Bestrahlung von mehr als 0,6 J/cm², z.B. eine Bestrahlung von mehr als 0,7 J/cm², z.B. eine Bestrahlung von mehr als 0,8 J/cm², z.B. eine Bestrahlung von mehr als 0,9 J/cm², z.B. eine Bestrahlung von mehr als 1 J/cm², z.B. eine Bestrahlung von mehr als 2 J/cm², z.B. eine Bestrahlung von mehr als 3 J/cm², z.B. eine Bestrahlung von mehr als 4 J/cm², z.B. eine Bestrahlung von mehr als 5 J/cm², z.B. eine Bestrahlung von mehr als 6 J/cm², z.B. eine Bestrahlung von mehr als 7 J/cm², z.B. eine Bestrahlung von mehr als 8 J/cm², z.B. eine Bestrahlung von mehr als 9 J/cm², z.B. eine Bestrahlung von mehr als 10 J/cm², z.B. eine Bestrahlung von mehr als 20 J/cm².

Beispielsweise kann die Bestrahlung in einem Bereich von ungefähr 1 J/cm2 bis ungefähr 25 J/cm² liegen, z.B. in einem Bereich von ungefähr 1 J/cm² bis ungefähr 10 J/cm², z.B. in einem Bereich von ungefähr 4 J/cm² bis ungefähr 9 J/cm², wobei die Bestrahlung in der Substratebene bei einem Bestrahlungspuls mit 300 µs Pulsdauer gemessen werden kann.

Gemäß verschiedenen Ausführungsformen können das erste Bestrahlen und das zweite Bestrahlen derart erfolgen, dass die gesamte bestrahlte Fläche des Substrats im Wesentlichen (z.B. mit einer Toleranz von weniger als 20%, oder weniger als 10% oder weniger als 5%) mit der gleichen Bestrahlung (bzw. der gleichen maximalen Intensität) bestrahlt wird. Beim periodischen Bestrahlen kann dieses derart erflogen, dass das Substrat im Wesentlichen immer mit der gleichen Bestrahlung oder Bestrahlungsverteilung (bzw. der gleichen Intensität oder Intensitätsverteilung) abschnittsweise bestrahlt wird, wobei die bestrahlten Teilbereich einander teilweise überlappen.

Gemäß verschiedenen Ausführungsformen können das erste Bestrahlen und das zweite Bestrahlen unmittelbar aufeinander folgen; d.h. dass kein weiteres (für das Substrat relevantes) Bestrahlen zwischen dem ersten Bestrahlen und dem zweiten Bestrahlen erfolgt.

Allgemein können physikalische oder chemische Prozesse, die mit dem Bestrahlen aktiviert werden sollen, eine Aktivierungsschwelle aufweisen, beispielsweise kann eine minimale Intensität (Iₘᵢₙ) der auf das Substrat auftreffenden Strahlung zum Aktivieren benötigt werden. Ferner können die aktivierten physikalischen oder chemischen Prozesse eine Zeitabhängigkeit aufweisen, so dass die Dauer des Bestrahlens relevant sein kann. Ferner können physikalische oder chemische Prozesse, die mit dem Bestrahlen aktiviert werden sollen, eine Aktivierungsschwelle aufweisen, beispielsweise kann eine minimale Bestrahlung (Hₘᵢₙ) (und/oder eine minimale Intensität) zum Aktivieren benötigt werden. Ferner kann der Strahlungspuls (oder können die Strahlungspulse) eine maximale Bestrahlung (Hₘₐₓ) (und/oder eine maximale Intensität) aufweisen und eine maximale Bestrahlung des Substrats pro Strahlungspuls ermöglichen. Die maximale Bestrahlung kann beispielsweise dadurch definiert sein, dass keine weitere Verbesserung der zu aktivierenden Eigenschaften erreicht wird, oder dass eine Verschlechterung der zu aktivierenden Eigenschaften verursacht wird, und/oder dass das Substrat bzw. die Beschichtung zerstört oder beeinträchtigt wird.

Beispielsweise kann eine Bestrahlung unterhalb der Aktivierungsschwelle keinen Einfluss auf das Substrat haben. Ferner kann sich die Bestrahlung verschiedener Strahlungspulse addieren, so dass es relevant sein kann, ob das Substrat überall mit einer vordefinierten Intensität oder mit einer vordefinierten Gesamt-Bestrahlung bestrahlt werden soll.

Der Bereich von der Aktivierungsschwelle bis zur maximalen Intensität oder maximalen Bestrahlung kann als Aktivierungsfenster verstanden werden. Bei einer niedrigen Aktivierungsschwelle (z.B. bei einem Bestrahlen mit einer maximalen Intensität von wesentlich mehr als Iₘᵢₙ) kann es notwendig sein, die gesamte Bestrahlung (H₁+H₂ in J/cm²) zu berücksichtigen, welcher die Bereiche des Substrats beim ersten Bestrahlen (mit H₁) und beim zweiten Bestrahlen (mit H₂) ausgesetzt sind.

Gemäß verschiedenen Ausfiihrungsformen kann die räumliche Strahlungsverteilung (z.B. die Strahldichteverteilung L(x) in W·m⁻²·sr⁻¹, die Intensitätsverteilung I(x) in W/mm² oder die Bestrahlungsverteilung H(x) in J/cm²) eines Strahlungspulses ein Maximum (oder auch ein Plateau aus vielen Maxima) und eine räumliche Halbwertsbreite, HWB, aufweisen, wobei der zeitliche Abstand des ersten Bestrahlens und des zweiten Bestrahlens ungefähr HWB/V ist. Somit können der mindestens eine erste Bereich und der mindestens eine zweite Bereich des Substrats genau einmal mit einer Bestrahlung (J/cm²) von größer als 50% des Maximums der Bestrahlung bzw. genau einmal mit einer Intensität (W/mm²) von größer als 50% des Maximums der Intensität bestrahlt werden.

In diesem Fall kann beispielsweise das Substrat abschnittsweise bestrahlt werden, wobei auch das gesamte abschnittsweise bestrahlte Substrat homogen bestrahlt wurde, d.h. nach dem Prozessieren war jeder Bereich auf dem Substrat im Wesentlichen der gleichen Bestrahlung ausgesetzt. Beispielsweise kann ein Substrat oder eine Beschichtung auf einem Substrat mittels eines Energieeintrags in das Substrat und/oder die Beschichtung verändert werden, wobei bei der Veränderung der Summenenergieeintrag (d.h. die gesamte Bestrahlung in Addition) relevant ist, so dass das Substrat oder die Beschichtung im Wesentlichen homogen mit einer vordefinierten Bestrahlung bestrahlt werden sollte. Ferner kann ein Substrat (oder eine Beschichtung des Substrats) auf einen Energieeintrag mit einer gewissen Toleranz reagieren, d.h. dass eine Bestrahlung mit einer gewissen Toleranz (ΔE/mm²), z.B. 20%, 10% oder 5%, im Wesentlichen dennoch zu den gewünschten Veränderungen in dem Substrat oder der Beschichtung führt. Dabei können folglich zweimal bestrahlte Bereiche im Wesentlichen der gleichen Bestrahlung ausgesetzt sein wie die nur einmal bestrahlten Bereiche. Damit sich die Bestrahlungen des ersten Bestrahlens und des zweiten Bestrahlens effektiv addieren können, muss die Aktivierungsschwelle im Vergleich zur maximalen Intensität gering sein, z.B. bei weniger als 10% oder bei weniger als 5% oder bei weniger als 1% der maximalen Intensität liegen. Mit anderen Worten muss das Aktivierungsfenster groß sein.

Gemäß verschiedenen Ausführungsformen kann die räumliche Strahlungsverteilung (z.B. die Strahldichteverteilung L(x) in W·m⁻²·sr⁻¹, die Intensitätsverteilung I(x) in W/mm² oder die Bestrahlungsverteilung H(x) in J/cm²) eines Strahlungspulses ein Maximum und eine räumliche Halbwertsbreite, HWB, aufweisen, wobei der zeitliche Abstand des ersten Bestrahlens und des zweiten Bestrahlens kleiner als HWB/V ist. Somit können der mindestens eine erste Bereich und der mindestens eine zweite Bereich des Substrats mindestens einmal mit einer Bestrahlung (J/cm²) von größer als 50% des Maximums der Bestrahlung bzw. mindestens einmal mit einer Intensität (W/mm²) von größer als 50% des Maximums der Intensität bestrahlt werden. Beispielsweise kann ein Substrat oder eine Beschichtung auf einem Substrat mittels eines Energieeintrags in das Substrat oder die Beschichtung verändert werden, wobei bei der Veränderung der Summenenergieeintrag (d.h. die gesamte Bestrahlung in Addition) nicht relevant ist sondern vielmehr die maximale Intensität des Bestrahlens. Somit kann das Bestrahlen des Substrats oder der Beschichtung derart erfolgen, dass jeder Bereich des Substrats oder der Beschichtung einmal der maximalen Intensität ausgesetzt war. Dabei können folglich zweimal bestrahlte Bereiche insgesamt einer größeren Bestrahlung ausgesetzt sein als die nur einmal bestrahlten Bereiche. Ferner kann ein Substrat oder eine Beschichtung auf einem Substrat auf die maximale Intensität mit einer gewissen Toleranz reagieren, d.h. dass eine maximale Intensität mit einer gewissen Toleranz (ΔP/mm²), z.B. 20%, 10% oder 5% im Wesentlichen dennoch zu den gewünschten Veränderungen in dem Substrat oder der Beschichtung führt.

Gemäß verschiedenen Ausführungsformen kann die räumliche Strahlungsverteilung (z.B. die Strahldichteverteilung L(x) in W·m⁻²·sr⁻¹, die Intensitätsverteilung I(x) in W/mm² oder die Bestrahlungsverteilung H(x) in J/cm²) eines Strahlungspulses ein Maximum aufweisen, wobei die räumliche Strahlungsverteilung Randbereiche aufweist, in denen die Strahlung (z.B. die Strahldichte, die Intensität oder die Bestrahlung) geringer ist als 90% des Maximums, und wobei die räumliche Strahlungsverteilung einen Plateaubereich zwischen den Randbereichen mit einer Plateaulänge, L_{P}, aufweist, in dem die Strahlung größer ist als 90% des Maximums; wobei der zeitliche Abstand des ersten Bestrahlens und des zweiten Bestrahlens ungefähr L_{P}/V ist. Somit können der mindestens eine erste Bereich und der mindestens eine zweite Bereich des Substrats genau einmal mit einer Strahlung von größer als 90% des Maximums bestrahlt werden. Dies kann die effizienteste Weise sein, das Substrat vollständig zu bestrahlen, so dass jeder Bereich des Substrats genau einmal der notwendigen Intensität (definiert durch den Plateaubereich) und/oder der notwendigen Bestrahlung ausgesetzt war. Dabei können folglich zweimal bestrahlte Bereiche insgesamt einer größeren Bestrahlung ausgesetzt sein als die nur einmal bestrahlten Bereiche; allerdings kann das Substrat eine relativ große Toleranz für die Bestrahlung (ΔE/mm²) aufweisen, z.B. mehr als 80% oder mehr als 90%. Ferner kann das Material ein schmales Aktivierungsfenster aufweisen, z.B. eine große Aktivierungsschwelle von beispielsweise 90% oder 80% der maximalen Intensität.

Gemäß verschiedenen Ausführungsformen kann die räumliche Strahlungsverteilung (z.B. die Strahldichteverteilung L(x) in W·m⁻²·sr⁻¹, die Intensitätsverteilung I(x) in W/mm² oder die Bestrahlungsverteilung H(x) in J/cm²) eines Strahlungspulses ein Maximum aufweisen, wobei die Strahlungsverteilung Randbereiche aufweist, in denen die Strahlung (z.B. die Strahldichte, die Intensität oder die Bestrahlung) geringer ist als 90% des Maximums, und wobei die räumliche Strahlungsverteilung einen Plateaubereich zwischen den Randbereichen mit einer Plateaulänge, L_{P}, aufweist, in dem die Strahlung größer ist als 90% des Maximums; wobei der zeitliche Abstand des ersten Bestrahlens und des zweiten Bestrahlens kleiner als L_{P}/V ist. Anschaulich kann beispielsweise ein zweimaliges Bestrahlen zu dem gleichen Ergebnis führen, wie ein einmaliges Bestrahlen, solange die Strahlung größer ist als 90% des Maximums. Dabei können folglich zweimal bestrahlte Bereiche insgesamt einer größeren Bestrahlung ausgesetzt sein als die nur einmal bestrahlten Bereiche; allerdings kann das Substrat eine relativ große Toleranz für die Bestrahlung (ΔE/mm²) aufweisen, z.B. mehr als 80% oder mehr als 90%. Ferner kann das Material ein schmales Aktivierungsfenster aufweisen, z.B. eine große Aktivierungsschwelle von beispielsweise 90% oder 80% der maximalen Intensität.

Gemäß verschiedenen Ausführungsformen kann die Strahlungsverteilung (z.B. die Strahldichteverteilung L(x) in W·m⁻²·sr⁻¹, die Intensitätsverteilung I(x) in W/mm² oder die Bestrahlungsverteilung H(x) in J/cm²) eines Strahlungspulses ein Maximum aufweisen, wobei die Strahlungsverteilung Randbereiche aufweist, in denen die Strahlung (z.B. die Strahldichte, die Intensität oder die Bestrahlung) geringer ist als 10% des Maximums, und wobei die räumliche Strahlungsverteilung eine effektive Bestrahlungsbereichslänge, L_{E}, zwischen den Randbereichen aufweist, in dem die Strahlung größer ist als 10% des Maximums; wobei der zeitliche Abstand des ersten Bestrahlens und des zweiten Bestrahlens ungefähr L_{E}N ist. Somit kann der mindestens eine erste Bereich und der mindestens eine zweite Bereich des Substrats genau einmal mit einer Strahlung von größer als 10% des Maximums bestrahlt werden. Dies kann die effizienteste Weise sein, das Substrat vollständig zu bestrahlen, so dass jeder Bereich des Substrats genau einmal der notwendigen Intensität (definiert durch den effektiven Bestrahlungsbereich) und/oder der notwendigen Bestrahlung ausgesetzt war. Dabei können folglich einmal bestrahlte Bereiche insgesamt einer größeren Bestrahlung ausgesetzt sein als die zweimal bestrahlten Bereiche; allerdings kann das Substrat eine relativ große Toleranz für die Bestrahlung (ΔE/mm²) aufweisen, z.B. mehr als 80% oder mehr als 90%. Ferner kann das Material ein großes Aktivierungsfenster aufweisen, z.B. eine geringe Aktivierungsschwelle von beispielsweise 10%, 5% oder 1% der maximalen Intensität.

Gemäß verschiedenen Ausführungsformen kann die Strahlungsverteilung (z.B. die Strahldichteverteilung L(x) in W·m⁻²·sr⁻¹, die Intensitätsverteilung I(x) in W/mm² oder die Bestrahlungsverteilung H(x) in J/cm²) eines Strahlungspulses ein Maximum aufweisen, wobei die räumliche Strahlungsverteilung Randbereiche aufweist, in denen die Strahlung (z.B. die Strahldichte, die Intensität oder die Bestrahlung) geringer ist als 10% des Maximums, und wobei die räumliche Strahlungsverteilung eine effektive Bestrahlungsbereichslänge, L_{E}, zwischen den Randbereichen aufweist, in dem die Strahlung größer ist als 10% des Maximums; wobei der zeitliche Abstand des ersten Bestrahlens und des zweiten Bestrahlens kleiner als L_{E}/V ist. Somit können der mindestens eine erste Bereich und der mindestens eine zweite Bereich des Substrats zumindest einmal mit einer Strahlung von größer als 10% des Maximums bestrahlt werden. Anschaulich kann beispielsweise ein zweimaliges Bestrahlen zu dem gleichen Ergebnis führen, wie ein einmaliges Bestrahlen, solange die Strahlung größer ist als 10% des Maximums. Dabei kann das Material (das Substrat oder die Beschichtung) eine relativ große Toleranz für die Bestrahlung (ΔE/mm²) aufweisen, z.B. mehr als 80% oder mehr als 90%.

Gemäß verschiedenen Ausführungsformen kann die Leistung, mit der die mindestens eine Blitzlampe gezündet wird, und somit die emittierte Strahlungsleistung angepasst werden, so dass das Maximum der Strahlungsverteilung beispielsweise im Vergleich zur Aktivierungsschwelle verschoben wird, jedoch die auf das Maximum normierte räumliche Strahlungsverteilung (anschaulich die Form der Strahlungsverteilung) gleich bleibt.

Gemäß verschiedenen Ausführungsformen kann zwischen dem Substrat und der Blendenstruktur ein Spalt bereitgestellt sein oder werden, wobei der Spalt eine Spalthöhe von weniger als 40 mm aufweist, z.B. von weniger als 30 mm, z.B. von weniger als 20 mm, z.B. von weniger als 10 mm, z.B. von weniger als 9 mm, z.B. von weniger als 8 mm, z.B. von weniger als 7 mm, z.B. von weniger als 6 mm, z.B. von weniger als 5 mm, z.B. von weniger als 4 mm, z.B. von weniger als 3 mm, z.B. von weniger als 2 mm.

Je nach Substratdicke kann somit die Blendenstruktur derart bereitgestellt sein, dass zwischen der Transportebene und der Blendenstruktur ein Spalt bereitgestellt ist, wobei der Spalt eine Spalthöhe von weniger als 50 mm aufweist, z.B. von weniger als 40 mm, z.B. von weniger als 30 mm, z.B. von weniger als 20 mm, z.B. von weniger als 10 mm, z.B. von weniger als 9 mm, z.B. von weniger als 8 mm, z.B. von weniger als 7 mm, z.B. von weniger als 6 mm, z.B. von weniger als 5 mm, z.B. von weniger als 4 mm, z.B. von weniger als 3 mm. Anschaulich kann die minimalste Spalthöhe für den Spalt bereitgestellt sein oder werden, welche noch einen unbeschadeten Substrattransport erlaubt.

Gemäß verschiedenen Ausführungsformen kann die Transportgeschwindigkeit in einem Bereich von ungefähr 0,5 m/min bis ungefähr 30 m/min liegen, z.B. in einem Bereich von ungefähr 1 m/min bis ungefähr 20 m/min, z.B. in einem Bereich von ungefähr 2 m/min bis ungefähr 15 m/min. Gemäß verschiedenen Ausführungsformen kann der Substrattransport mit einer konstanten Geschwindigkeit erfolgen, oder zumindest mit einer im zeitlichen Mittel (z.B. gemittelt über 1 s, 5 s, 10 s, 30 s oder 1 min) konstanten Geschwindigkeit. Anschaulich können zwei aufeinanderfolgende Bestrahlungen einen zeitlichen Abstand zueinander von beispielsweise mehr als 0,5 s, mehr als 1 s, mehr als 2 s, mehr als 5 s, mehr als 10 s, mehr als 20 s, mehr als 30 s oder mehr als 1 min aufweisen, so dass kleinere Schwankungen der Transportgeschwindigkeit oder im Verhältnis dazu kurze Unterbrechungen des Substrattransports vernachlässigbar sein können.

Gemäß verschiedenen Ausführungsformen kann der jeweils mindestens eine, mittels der mindestens einen Blitzlampe erzeugte Strahlungspuls eine Pulsdauer von weniger als 20 ms aufweisen.

Gemäß verschiedenen Ausführungsformen kann der jeweils mindestens eine mittels der mindestens einen Blitzlampe erzeugte Strahlungspuls das Substrat mit einer mittleren Bestrahlung (z.B. gemittelt über die gesamte mittels des jeweiligen erzeugten Strahlungspulses bestrahlte Fläche) in einem Bereich von ungefähr 1 J/cm² bis ungefähr 25 J/cm² bestrahlen.

Gemäß verschiedenen Ausführungsformen können das erste Bestrahlen und das zweite Bestrahlen jeweils eine Bestrahlungsdauer von weniger als 0,1 s aufweisen, z.B. bei einer Pulsdauer der verwendeten Strahlungspulse von weniger als 20 ms. Die Bestrahlungsdauer des erstens Bestrahlens und die Bestrahlungsdauer des zweiten Bestrahlens kann als Zeitdauer definiert sein, welcher vom Anfang des ersten Bestrahlens bis Ende des ersten Bestrahlens und entsprechend vom Anfang des zweiten Bestrahlens bis zum Ende des zweiten Bestrahlens gemessen wird. Dabei kann der Anfang eines Strahlungspulses dadurch definiert sein, dass die Intensität beispielsweise 1% (oder 5%) der maximalen Intensität übersteigt; und ferner kann das Ende des Strahlungspulses dadurch definiert sein, dass die Intensität beispielsweise 1 % (oder 5%) der maximalen Intensität unterschreitet. Anschaulich kann ein Grenzwert relativ zur maximalen Pulshöhe des Strahlungspulses definiert sein, welcher den Anfang und das Ende des Strahlungspulses definiert.

Gemäß verschiedenen Ausführungsformen können das erste Bestrahlen und das zweite Bestrahlen derart bereitgestellt sein oder werden, dass das gesamte Substrat jeweils mit einer Bestrahlung in einem Bereich von ungefähr 1 J/cm² bis ungefähr 25 J/cm² bestrahlt wird.

Gemäß verschiedenen Ausführungsformen kann eine Prozesskammeranordnung folgendes aufweisen: mindestens eine Prozesskammer (bzw. Bestrahlungskammer); eine mit der Prozesskammer gekoppelte Blitzlampenanordnung zum Bestrahlen eines Substrats innerhalb eines Bestrahlungsbereichs in der Prozesskammer; ein Transportsystem zum Transportieren eines zu bestrahlenden Substrats durch den Bestrahlungsbereich hindurch, wobei das Transportsystem eine Transportebene und eine Transportrichtung definiert; eine Blendenstruktur, welche den Bestrahlungsbereich entlang der Transportrichtung begrenzt; wobei zwischen der Transportebene und der Blendenstruktur ein Spalt bereitgestellt ist, wobei der Spalt eine Spalthöhe (z.B. gemessen entlang einer Richtung senkrecht zur Transportebene) von weniger als 5 cm aufweist. Dabei kann eine Transportebene eine planare Transportfläche (z.B. zum Transportieren plattenförmiger Substrate) oder auch eine gekrümmte Transportfläche (z.B. zum Transportieren von Bandsubstraten oder Foliensubstrate) aufweisen, beispielsweise je nach Art des Transportsystems.

Gemäß verschiedenen Ausführungsformen kann die Blendenstruktur derart eingerichtet sein, dass diese den Bestrahlungsbereich entlang der Transportrichtung auf eine Bestrahlungsbereichslänge, L, begrenzt; wobei das Transportsystem eine Steuerung oder Regelung derart aufweist, dass das Substrat mit einer Transportgeschwindigkeit, V, transportiert wird; und wobei die Blitzlampenanordnung eine Steuerung oder Regelung derart aufweist, dass ein zeitlicher Abstand zwischen einem ersten Bestrahlen des Substrats und einem erneuten Bestrahlen des Substrats größer ist als L/2V, so dass mindestens ein erster Bereich des Substrats genau einmal bestrahlt wird, und kleiner ist als L/V, so dass mindestens ein zweiter Bereich des Substrats genau zweimal bestrahlt wird.

Ausführungsbeispiele der Erfindung sind in den Figuren dargestellt und werden im Folgenden näher erläutert.

Es zeigen
- Figur 1: ein schematisches Ablaufdiagramm für ein Verfahren zum Bestrahlen eines Substrats in einer Prozesskammer, gemäß verschiedenen Ausführungsformen;
- Figur 2A: einen Teil einer Prozesskammeranordnung in einer schematischen perspektivischen Ansicht, gemäß verschiedenen Ausführungsformen;
- Figur 2B: eine Prozesskammeranordnung in einer schematischen Seitenansicht oder Querschnittsansicht, gemäß verschiedenen Ausführungsformen;
- Figur 3A: zwei räumliche Strahlungsverteilungen entlang der Transportrichtung für verschiedenen Spalthöhen zwischen Blendenstruktur und Substrat, gemäß verschiedenen Ausführungsformen;
- Figur 3B: eine schematische Darstellung des Verhaltens einer physikalischen Größe P, welche eine Eigenschaft des Substrats beschreibt, in Abhängigkeit von der beim Bestrahlen in das Substrat eingetragenen Energie, gemäß verschiedenen Ausführungsformen;
- Figuren 3C: bis 3H jeweils räumliche Strahlungsverteilungen für ein erstes Bestrahlen und ein zweites Bestrahlen mit Bezug zum zu bestrahlenden Substrat, gemäß verschiedenen Ausführungsformen;
- Figur 4: eine tabellarische Übersicht für den elektrischen Flächenwiderstand in Abhängigkeit von verschiedenen Bereichen auf dem Substrat und der Spalthöhe zwischen Substrat und Blendenstruktur, gemäß verschiedenen Ausführungsformen;
- Figuren 5A und 5B: eine räumliche Verteilung des Farbwertes eines abschnittsweise bestrahlten Substrats, gemäß verschiedenen Ausführungsformen;
- Figuren 6A und 6B: jeweils eine Prozesskammeranordnung in einer schematischen Seitenansicht oder Querschnittsansicht, gemäß verschiedenen Ausführungsformen;
- Figur 7: eine Prozesskammeranordnung in einer schematischen Seitenansicht oder Querschnittsansicht, gemäß verschiedenen Ausführungsformen; und
- Figuren 8A bis 8D: jeweils eine Prozesskammeranordnung in einer schematischen Seitenansicht oder Querschnittsansicht, gemäß verschiedenen Ausführungsformen.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Gemäß verschiedenen Ausführungsformen werden ein Verfahren sowie eine entsprechend eingerichtete Vorrichtung zum Kurzzeittempern eines Substrats bereitgestellt, wobei das Substrat eine Beschichtung aufweisen kann. Beispielsweise wird hierin eine Verfahren zum Kurzzeittempern einer low-E Beschichtung oder zum Kurzzeittempern einer TCO Beschichtung beschrieben. Das Substrat kann beispielsweise Glassubstrat sein, oder jedes andere geeignete Werkstück, mit einer Beschichtung auf mindestens einer Seite bzw. Oberfläche des Substrats. Für das Kurzzeittempern von low-E Schichten und/oder ITO Schichten können beispielsweise verschiedene Strahlungsquellen (Lichtquellen) verwendet werden. Diese Schichten können beispielsweise mit einer Bestrahlungsdauer (Belichtungszeit) von ungefähr 3 ms bestrahlt werden, wobei die in das Substrat eingetragene Energie (die Bestrahlung) in einem Bereich von ungefähr 10 J/cm² bis 25 J/cm² liegen kann.

Beim abschnittsweisen aneinandergereihten Bestrahlen eines Substrats, welches länger als der Bestrahlungsbereich der Blitzlampen ist, können sogenannte Stitching-Effekte auftreten. Anschaulich können Stitching-Effekte in Abhängigkeit von den bestrahlten Materialien und/oder den verwendeten Prozessparametern entstehen, wobei diese Effekte mit einer Doppelbestrahlung (Doppelbelichtung) zusammenhängen, welche erforderlich sein kann, wenn das Belichtungsfeld kleiner als die Substratoberfläche ist. Anschaulich kann ein "Aneinanderheften" bzw. eine "Randüberlappung" mehrerer Bestrahlungen oder mehrerer Belichtungsfelder zur Behandlung des Substrats notwendig sein. Der beispielsweise für eine low-E Beschichtung beobachtete Stitching-Effekt kann sich in einer starken Farbverschiebung zwischen einfach und doppelt bestrahlten (belichteten) Bereichen auf dem Substrat äußern. In einem solchen Fall, z.B. wenn die Beschichtung auf dem Glassubstrat inhomogen bestrahlt wurde und somit inhomogen bezüglich der Farbwerte und/oder der Transparenz ist, kann das Glassubstrat beispielsweise nicht mehr als Architekturglas verwendet werden.

Ein Vergrößern des Bestrahlungsbereichs bzw. des Bestrahlungsfeldes auf beispielsweise bis zu 3 m x 6 m kann mit sehr großem technischen Aufwand verbunden sein. Ferner kann selbst ein derart großes Bestrahlungsfeld nicht ausreichend sein, um ein Substratband (auch als Endlossubstrat bezeichnet) oder ein Bandsubstrat abschnittsweise homogen zu bestrahlen.

Gemäß verschiedenen Ausführungsformen werden ein Verfahren und eine entsprechend eingerichtete Vorrichtung beschrieben, wobei ein Substrat, welches beispielsweise eine low-E Beschichtung oder eine TCO Beschichtung aufweist, abschnittsweise derart bestrahlt wird, dass die Farbverschiebungen in verschieden bestrahlten Bereichen (z.B. genau einmal bestrahlten Bereichen und mehrmals bestrahlten Bereichen) der Beschichtung entweder vernachlässigbar klein sind oder unterhalb der Auflösungsgrenze liegen. Dabei wurden beispielsweise Bestrahlungszeiten (Belichtungszeiten) in einem Bereich von ungefähr 0,28 ms bis ungefähr 0,55 ms verwendet mit einer Bestrahlung in einem Bereich von ungefähr 4 J/cm² bis ungefähr 6 J/cm².

In verschiedenen Ausführungsformen wird beispielsweise berücksichtigt, dass die Pulsdauer beim Bestrahlen mittels Blitzlampen einen Einfluss auf die Farbverschiebung zwischen einer Einfach- und Doppelbestrahlung haben kann. Beispielsweise kann eine Pulsdauer beim Bestrahlen von beispielsweise ungefähr 0,3 ms zu keiner Farbverschiebung zwischen einer Einfach- und Doppelbestrahlung führen, wobei im Gegensatz dazu eine Pulsdauer beim Bestrahlen von ungefähr 3 ms zu einer Farbverschiebung zwischen einer Einfach- und Doppelbestrahlung führen kann.

Herkömmlicherweise werden zum Bestrahlen bzw. Belichten von Substraten, wie beispielsweise einem Substratband (Endlossubstrat) oder einem Bandsubstrat, mehrere Bestrahlungen (Belichtungen) in kurzem Abstand zueinander verwendet, z.B. werden die Substrate dadurch bestrahlt, dass Blitzlampen mit einer Frequenz in einem Bereich von ungefähr 1 Hz bis ungefähr 1000 Hz gezündet werden. Dabei wird das Substrat entsprechend oft bestrahlt, was anschaulich eher einem kontinuierlichen Bestrahlen entspricht, verglichen mit den typischen Substrattransportgeschwindigkeiten im Bereich von einigen Metern pro Minute.

Bei langen Blitzlampen, z.B. bei zylinderförmigen Blitzlampen mit einer Länge in einem Bereich von ungefähr 1 m bis ungefähr 5 m (oder auch länger als 5 m), kann es ungünstig sein, diese mit den herkömmlicherweise verwendeten großen Blitzfrequenzen zu betreiben, z.B. kann die Lebensdauer der Blitzlampen von einer maximalen Anzahl von Blitzen limitiert sein, so dass die Anzahl der Blitze eine wesentliche Rolle spielen kann. Anschaulich kann die unterbrechungsfreie (wartungsfreie) Betriebszeit einer Prozessieranlage ungefähr verdoppelt werden, wenn es gelingt, die Blitzfrequenz zum vollständigen Bestrahlen der prozessierten Substrate zu halbieren. Gemäß verschiedenen Ausführungsformen kann das Bestrahlen eines Substrats derart erfolgen, dass so wenig wie möglich Blitze genutzt werden, um das Substrat abschnittsweise homogen zu bestrahlen bzw. mittels eines abschnittsweisen Bestrahlens des Substrats die Beschichtung auf dem Substrat homogen zu verändern.

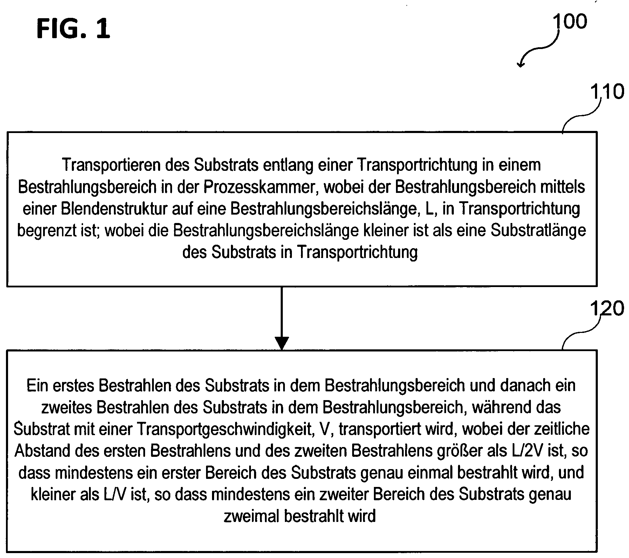

**Fig.1** veranschaulicht ein schematisches Ablaufdiagramm für ein Verfahren 100 zum Bestrahlen eines Substrats in einer Prozesskammer, gemäß verschiedenen Ausführungsformen. Dabei kann das Verfahren 100 zumindest Folgendes aufweisen: in 110, Transportieren des Substrats entlang einer Transportrichtung in einem Bestrahlungsbereich in der Prozesskammer, wobei der Bestrahlungsbereich mittels einer Blendenstruktur auf eine Bestrahlungsbereichslänge, L, in Transportrichtung begrenzt ist; wobei die Bestrahlungsbereichslänge kleiner ist als eine Substratlänge des Substrats in Transportrichtung; und, in 120, ein erstes Bestrahlen des Substrats in dem Bestrahlungsbereich und danach ein zweites Bestrahlen des Substrats in dem Bestrahlungsbereich, während das Substrat mit einer Transportgeschwindigkeit, V, transportiert wird, wobei der zeitliche Abstand des ersten Bestrahlens und des zweiten Bestrahlens größer als L/(2V) ist, so dass mindestens ein erster Bereich des Substrats genau einmal bestrahlt wird, und kleiner als L/V ist, so dass mindestens ein zweiter Bereich des Substrats genau zweimal bestrahlt wird.

Anschaulich können somit die jeweils aufeinanderfolgenden Bestrahlungen in einem Überlappungsbereich auf dem Substrat überlappen, so dass das Substrat in dem Überlappungsbereich zweimal bestrahlt wird und außerhalb des Überlappungsbereichs, in den restlichen Bereichen des Substrats, nur einmal bestrahlt wird. Wie vorangehend beschrieben, können die Prozessparameter derart gewählt werden, dass das Substrat in dem genau einmal bestrahlten Bereich genauso verändert wird wie in dem genau zweimal bestrahlten Bereich.

Ferner können das erste Bestrahlen und das zweite Bestrahlen in der hierin beschriebenen Weise periodisch wiederholt erfolgen, wobei jeweils die aufeinanderfolgenden Bestrahlungen in einem Überlappungsbereich auf dem Substrat überlappen, so dass beispielsweise ein Substratband (Endlossubstrat), ein Bandsubstrat oder ein Substrat, welches länger als die doppelte Bestrahlungsbereichslänge ist, bestrahlt werden kann.

Im Folgenden werden verschiedene Modifikationen und/oder Details des Verfahrens 100 zum Bestrahlen eines Substrats in einer Prozesskammer beschrieben und sowie eine Prozesskammeranordnung zum Durchführen des Verfahrens 100, wobei sich die vorangehend beschriebenen grundlegenden Merkmale und Funktionsweisen analog einbeziehen lassen. Ferner können die nachfolgend beschriebenen Merkmale und Funktionsweisen analog auf das Verfahren 100 übertragen werden oder mit dem Verfahren 100 kombiniert werden.

Gemäß verschiedenen Ausführungsformen kann eine Prozesskammeranordnung 200 zum Prozessieren eines Substrats, z.B. zum Bestrahlen eines Substrats gemäß dem Verfahren 100, folgendes aufweisen: mindestens eine Prozesskammer; eine mit der Prozesskammer gekoppelte Blitzlampenanordnung zum Bestrahlen des Substrats innerhalb eines Bestrahlungsbereichs in der Prozesskammer; ein Transportsystem zum Transportieren eines zu bestrahlenden Substrats durch den Bestrahlungsbereich hindurch, wobei das Transportsystem eine Transportebene und eine Transportrichtung definiert; eine Blendenstruktur (z.B. aufweisend eine Blende oder eine Anordnung mehrerer Blenden und/oder ein Reflektor oder eine Anordnung mehrerer Reflektoren), welche den Bestrahlungsbereich entlang der Transportrichtung begrenzt, wobei zwischen der Transportebene und der Blendenstruktur ein Spalt bereitgestellt ist, wobei der Spalt eine Spalthöhe von weniger als 5 cm aufweist.

Anschaulich kann es zum abschnittsweisen (sequenziellen) Bestrahlen eines Substrat, welches länger ist als die Länge des Bestrahlungsbereichs, notwendig oder hilfreich sein, den Spalt zwischen der Blendenstruktur und dem zu bestrahlenden Substrat möglichst gering bereitzustellen. Anschaulich kann nur so eine von der Strahlungsquelle emittierte räumliche Intensitätsverteilung, in diesem Fall definiert durch die Blitzlampenanordnung und die Blendenstruktur, in geeigneter Weise in das zu bestrahlende Substrat bzw. in eine zu bestrahlende Beschichtung auf dem Substrat eingetragen werden. Gemäß verschiedenen Ausführungsformen kann das Substrat ein transparentes Substrat (z.B. ein Glassubstrat) mit einer Low-E-Beschichtung oder ein transparentes Substrat (z.B. ein Glassubstrat) mit einer TCO-Beschichtung sein.

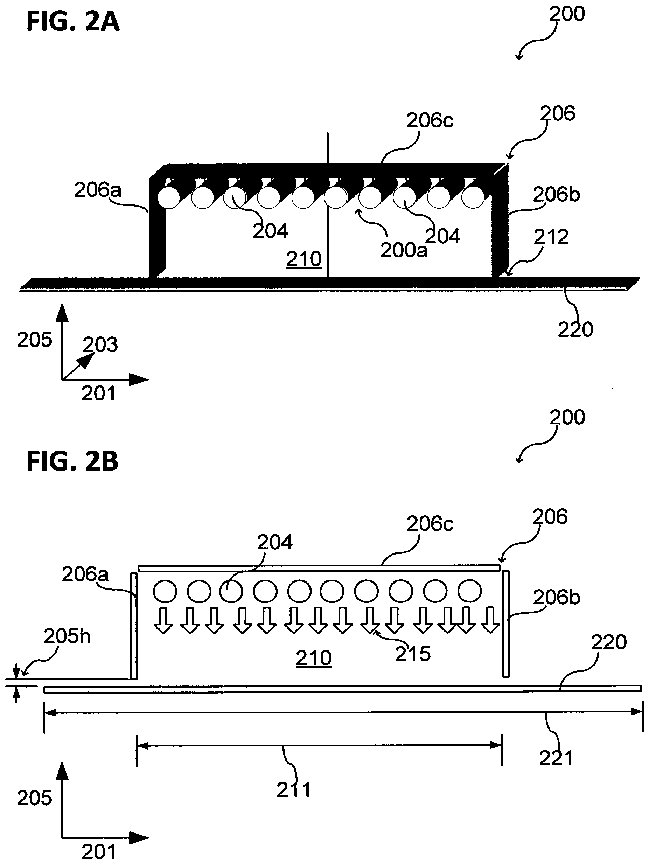

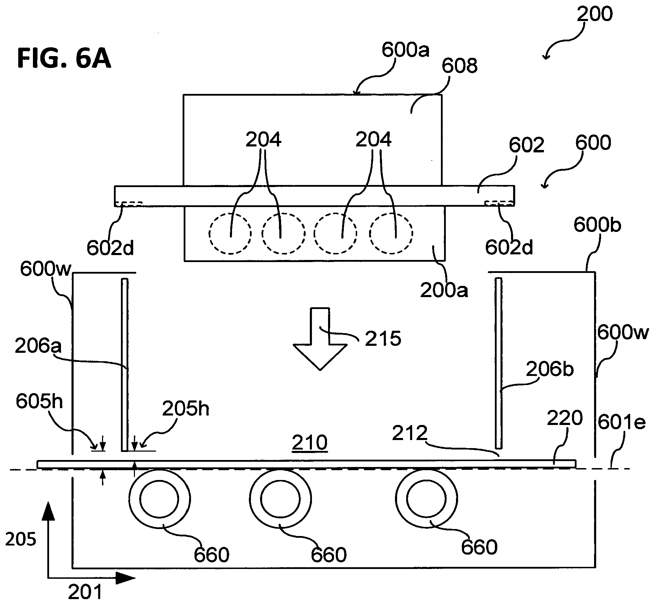

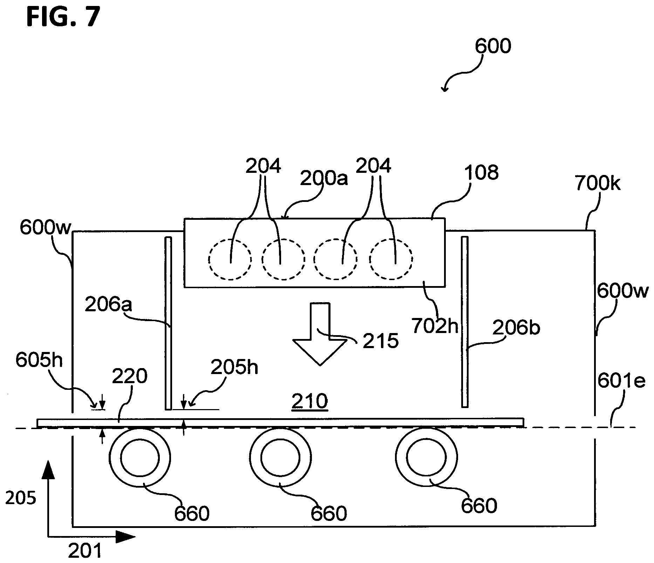

**Fig.2A** und **Fig.2B** veranschaulichen jeweils eine Prozesskammeranordnung 200 bzw. einen Teil einer Prozesskammeranordnung 200 in einer schematischen perspektivischen Ansicht (in Fig.2A) und in einer schematischen Seitenansicht oder Querschnittsansicht (in Fig.2B), gemäß verschiedenen Ausführungsformen. Die Prozesskammeranordnung 200 kann beispielsweise eine Blitzlampenanordnung 200a mit einer Vielzahl von Blitzlampen 204 aufweisen sowie einer Blendenstruktur 206, welche beispielsweise in einer Prozesskammer (vgl. beispielsweise Fig.6A oder Fig.7) derart relativ zu einem zu bestrahlenden Substrat 220 angeordnet sein können, dass eine Oberfläche des zu bestrahlenden Substrat 220 abschnittsweise bestrahlt werden kann. Das Substrat 220 kann beispielsweise mittels einer Transportvorrichtung (vgl. beispielsweise Fig.6A oder Fig.7) entlang der Transportrichtung 201 durch einen Bestrahlungsbereich 210 hindurch transportiert werden. Anschaulich kann das zu bestrahlenden Substrat 220 derart transportiert werden, dass sich eine Relativgeschwindigkeit, V, zwischen den zu bestrahlenden Abschnitten des Substrats 220 und der Blitzlampenanordnung 200a ergibt. Die Blitzlampenanordnung 200a kann beispielsweise in der Prozesskammer der Prozesskammeranordnung 200 ortsfest montiert sein und das Substrat 220 kann mit einer Transportgeschwindigkeit, V, entlang der Transportrichtung durch die Prozesskammer der Prozesskammeranordnung 200 hindurch transportiert werden.

Anschaulich kann die Prozesskammeranordnung 200 eine Blitzlampenanordnung 200a aufweisen mit einer Blitzlampe 204 oder mit einer Vielzahl von Blitzlampen 204. Die Blitzlampenanordnung 200a kann auch als Lampenfeld 200a oder Blitzlampenfeld 200a bezeichnet werden. Dabei kann die Blitzlampenanordnung 200a ferner eine Lagerung aufweisen zum Lagern und/oder Versorgen (z.B. mit elektrischer Energie und/oder einem Kühlmedium) der mindestens einen Blitzlampe 204.

Gemäß verschiedenen Ausführungsformen kann die Prozesskammeranordnung 200 eine Blendenstruktur 206 aufweisen, wobei zumindest ein Teil der Blendenstruktur 206 den Bestrahlungsbereich 210 entlang der Transportrichtung 201 begrenzt. Anschaulich können sich eine erste Blende 206a und eine zweite Blende 206b (mit anderen Worten ein erster Reflektor 206a und ein zweiter Reflektor 206b) der Blendenstruktur 206 zumindest abschnittsweise senkrecht zur Transportrichtung 201 derart erstrecken, dass der Bestrahlungsbereich 210 entlang der Transportrichtung 201 auf eine Bestrahlungsbereichslänge 211 (anschaulich die Länge 211 des Bestrahlungsbereichs 210 gemessen in Transportrichtung 201 bzw. der räumliche Abstand 211 von der erste Blende 206a zu der zweiten Blende 206b gemessen in Transportrichtung 201) begrenzt wird. Alternativ können sich ein erster Abschnitt 206a und ein zweiter Abschnitt 206b der Blendenstruktur 206 senkrecht zur Transportrichtung derart erstrecken, dass der Bestrahlungsbereich 210 entlang der Transportrichtung 201 auf eine Bestrahlungsbereichslänge 211 begrenzt wird.

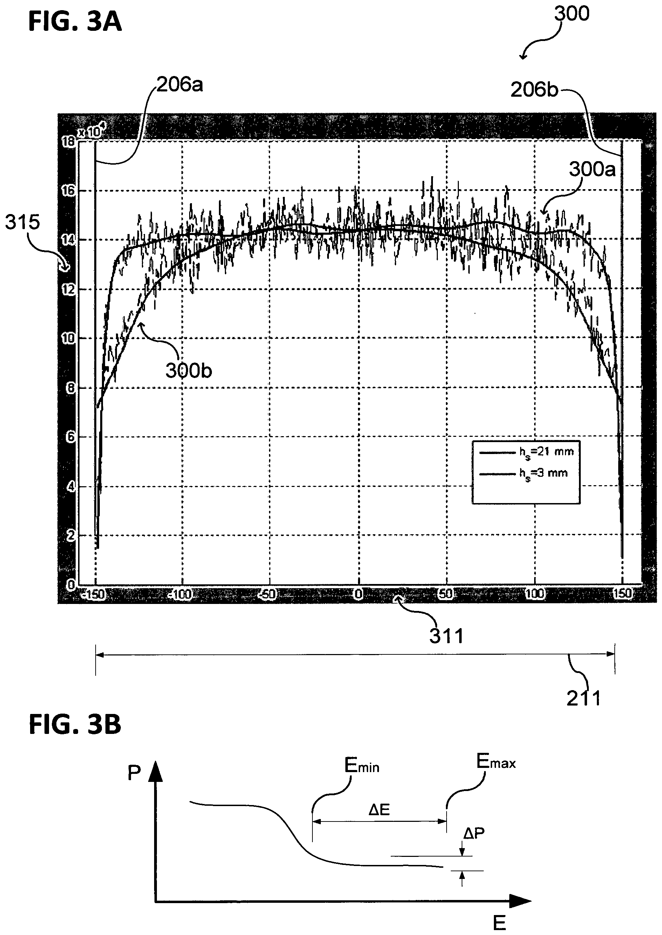

Zusätzlich kann die Blendenstruktur 206 eine dritte Blende 206c (oder einen dritten Reflektor 206c) bzw. einen dritten Abschnitt 206c aufweisen, welcher beispielsweise auf der dem zu bestrahlenden Substrat 220 abgewandten Seite der Blitzlampen 204 angeordnet ist. Anschaulich können mehrere Reflektoren 206a, 206b, 206c gemeinsam mit der Blitzlampenanordnung 200a eine Strahlungsquelle bereitstellen, wobei ein vordefinierter Bestrahlungsbereich 210 mit der Bestrahlungsbereichslänge 211 bereitgestellt wird, in dem das Substrat 220, welches eine Substratlänge 221 aufweist, abschnittsweise bestrahlt werden kann. Dabei kann die Substratlänge 221 größer sein als die Bestrahlungsbereichslänge 211, z.B. mehr als 1,5 mal so groß, mehr als doppelt so groß, oder mehr als fünfmal so groß. Die Substratlänge 221 eines Substratbandes (bzw. Endlossubstrats) oder eines Bandsubstrats kann hierin gegenüber der Bestrahlungsbereichslänge 211 als sehr groß oder unendlich betrachtet werden. Die mittels der Reflektoren 206a, 206b, 206c (bzw. Blenden) und der Blitzlampenanordnung 200a bereitgestellte Strahlungsquelle kann Strahlung 215 gepulst (als Strahlungspuls oder Strahlungsblitz) emittieren, wobei der Strahlungspuls eine räumliche (ortsabhängige) Strahlungsverteilung entlang der Transportrichtung 201 aufweist (vgl. beispielsweise Fig.3A). In Breitenrichtung 203 (d.h. quer zur Transportrichtung 201 und quer zur Richtung 205) kann die gepulst emittierte Strahlung 215 eine im Wesentlichen konstante (d.h. ortsunabhängige) räumliche Strahlungsverteilung aufweisen.

Beispielsweise können Randabfälle der Strahlungsverteilung auch mittels Reflektoren (z.B. Stirnreflektoren) reduziert sein oder werden. Ferner kann die Substratbreite kleiner als die Lampenlänge gewählt sein oder werden, so dass ein eventuell auftretender Randabfall (z.B. quer zur Transportrichtung) für die Bestrahlung des Substrats unwesentlich sein kann.

Gemäß verschiedenen Ausführungsformen kann zwischen der Oberfläche des zu bestrahlenden Substrats 220, welche der Blitzlampenanordnung zugewandt ist, und der Blendenstruktur 206 ein Spalt 212 mit der Spalthöhe 205h bereitgestellt sein oder werden, wobei die Spalthöhe 205h geringer ist als ungefähr 4 cm, z.B. geringer als ungefähr 3 cm, z.B. geringer als ungefähr 2 cm. Sofern es den Substrattransport nicht behindert, kann die Spalthöhe 205h auch geringer sein als 1 cm, z.B. geringer als 9 mm, z.B. geringer als 8 mm, z.B. geringer als 7 mm, z.B. geringer als 6 mm, z.B. geringer als 5 mm, z.B. geringer als 4 mm, z.B. geringer als 3 mm, z.B. geringer als 2 mm.

Gemäß verschiedenen Ausführungsformen kann das Substrat 220 in einer Transportebene oder Transportfläche transportiert werden, wobei sich der Abstand der Blendenstruktur 206 von der Transportebene entsprechend unter Berücksichtigung der Spalthöhe 205h und der Substratdicke ergibt (vgl. beispielsweise Fig.6A, Fig.7 oder Fig.8C). Ferner kann die Blendenstruktur 206 den Bestrahlungsbereich 210 auch in der Breitenrichtung 203 (quer zur Transportrichtung 201 und zur Höhenrichtung 205) begrenzen.

Mittels einer derart bereitgestellten Prozesskammeranordnung 200 kann beispielsweise eine RTP-Behandlung von großen Substraten 220 mittels sequenzieller Bestrahlung (Belichtung) erfolgen, wie hierin beschrieben ist. Das zu bestrahlende Substrat 220 kann beispielsweise eine Breite (in Breitenrichtung 203) von mehr als 1 m aufweisen, z.B. eine Breite in einem Bereich von ungefähr 1 m bis ungefähr 5 m. Die Homogenität der Bestrahlung in Breitenrichtung 203 kann dadurch gewährleistet sein, dass entsprechend lange Blitzlampen 204 verwendet werden, welche sich in die Breitenrichtung 203 erstrecken.

Für große Substrate 220, wie beispielsweise im Architekturglasbereich zum Einsatz kommen, kann eine RTP-Behandlung mit einem einzelnen Blitz (Strahlungsblitz oder Strahlungspuls) aus verschiedenen Gründen nicht sinnvoll bzw. auch nicht möglich sein. Zum einen müsste das Blitzlampenfeld so groß sein, dass eine derartige Anlage sowohl in der Anschaffung als auch im Betrieb sehr teuer wäre. Zum anderen könnte ein RTP-Anlagenmodul in einer solchen Größe nicht in bestehende Anlagen integriert werden, da beispielsweise der entsprechende Bauraum üblicherweise nicht vorhanden ist. Gemäß verschiedenen Ausführungsformen erfolgt das Bestrahlen (das Belichten) des Substrats 220 in Substrattransportrichtung 201 sequenziell (abschnittsweise), bzw. anschaulich wird das Bestrahlen auf jeweils kürzeren Bereichen 211 durchgeführt. Damit kann das Lampenfeld 200a, wie beispielsweise in Fig.2A und 2B dargestellt ist, in dessen Größe (mit anderen Worten in dessen Länge in Transportrichtung) reduziert werden.

Gemäß verschiedenen Ausführungsformen kann die Blendenstruktur 206 einen Reflektorkasten 206 bilden, welcher das Bestrahlen des Substrats 220 mittels der Blitzlampenanordnung 200a im Wesentlichen auf den Bestrahlungsbereich 210 innerhalb des Reflektorkastens 206 beschränken kann. Ferner kann mittels des Reflektorkastens 206 eine möglichst homogene Strahlungsverteilung bezüglich der Substratebene (z.B. bezüglich der zu bestrahlenden Oberfläche des Substrats 220) erzeugt werden. Dabei kann der Reflektorkasten 206 zwei einander gegenüberliegende Seitreflektoren 206a, 206b aufweisen, welche den Bestrahlungsbereich 210 entlang der Transportrichtung 201 begrenzen.

Diese Behandlungsweise bedingt aber, dass es an der Grenze zwischen zwei benachbarten Bestrahlungsbereichen (Belichtungsbereichen) auf dem Substrat 220 zur Inhomogenität in der Schichtaktivierung kommen kann (Stitching-Effekt). Diese Inhomogenität kann sich beispielsweise auf die optoelektrischen Eigenschaften der Schicht derart auswirken, dass das Resultat der RTP-Behandlung nicht akzeptabel wäre. Gemäß verschiedenen Ausführungsformen wird die Prozesskammeranordnung 200 derart betrieben, vgl. beispielsweise das Verfahren 100, dass die Homogenität im Grenzbereich zweier Bestrahlungsbereiche auf dem Substrat 220 hinsichtlich der jeweiligen Anforderungen gewährleistet ist.

Verschiedene Ausführungsformen basieren beispielsweise darauf, dass die resultierende Homogenität der Substrataktivierung wesentlich von dem Abstand 205h zwischen dem Seitreflektor 206a, 206b und dem Substrat beeinflusst sein kann (vgl. Fig.2A und 2B). Dieser Abstand 205h kann aufgrund des Substrattransports erforderlich sein, damit es zu keinem Kontakt zwischen Substrat 220 und Seitreflektor 206a, 206b kommt. Allerdings bedingt diese Öffnung (der Spalt 212) des Reflektorkastens 206 auch ein Abfall der Bestrahlungsstärke (Beleuchtungsstärke) im Bereich nahe der Seitenreflektoren 206a, 206b, vgl. beispielsweise Fig.3A.

**Fig.3A** veranschaulicht zwei räumliche Strahlungsverteilungen 300a, 300b entlang der Transportrichtung 301 für verschiedenen Spalthöhen 205h (in Fig. 3A mit hₛ bezeichnet) zwischen der Blendenstruktur 206 und dem Substrat 220, gemäß verschiedenen Ausführungsformen. Dabei ist die ortsabhängige Bestrahlung 315 in beliebigen Einheiten über der Position 311 (z.B. in Millimetern) in dem Bestrahlungsbereich 210 entlang der Transportrichtung 201 aufgetragen. Dabei sind ferner die Positionen (jeweils bei +150 mm und - 150 mm) der Seitreflektoren 206a, 206b veranschaulicht bei einer beispielhaft dargestellten Bestrahlungsbereichslänge 211 von 300 mm.

In Fig.3A ist dargestellt, dass mittels der Reduktion des Abstands 205h von beispielsweise 21 mm (Graph 300b) auf 3 mm (Graph 300a) der Randbereich, in welchem beispielsweise die Bestrahlungsstärke abfällt, reduziert werden kann, und dass folglich der Plateaubereich zwischen den Randbereichen vergrößert werden kann. Beispielsweise kann sich der Plateaubereich bei einer Spalthöhe 205h von ungefähr 3 mm von ungefähr -130 mm bis ungefähr 130 mm erstrecken, wobei sich hingegen der Plateaubereich bei einer Spalthöhe 205h von ungefähr 21 mm nur von ungefähr -90 mm bis ungefähr 90 mm erstrecken kann. Gemäß verschiedenen Ausführungsformen wurde erkannt, dass für ein effizientes sequentielles Bestrahlen des Substrats 220, wie hierin beschrieben ist, die Spalthöhe 205h einen wesentlicher Parameter sein kann. Gemäß verschiedenen Ausführungsformen kann die Spalthöhe geringer sein als ungefähr 20 mm. Dabei kann bei der benötigen minimalen Spalthöhe 205h das zu bestrahlende Material berücksichtigt sein oder werden.

Ferner können mittels der Blitzfrequenz (z.B. mittels des Zeitabstands aufeinanderfolgender Bestrahlungen) und der Substratgeschwindigkeit (mit anderen Worten der Transportgeschwindigkeit) eine Überlappungsbreite eingestellt werden, in der sich die beiden aufeinander folgenden Bestrahlungen (Belichtungen) auf dem Substrat 220 überlappen. In Abhängigkeit des zu behandelnden Substrats 220 können die Spalthöhe 205h und die Überlappungsbreite der Bestrahlungen auf dem Substrat 220 derart eingestellt werden, dass es zu keiner messbaren (oder einer vernachlässigbar geringen) Inhomogenität von optoelektrischen Eigenschaften in dem behandelten Substrat 220 kommt. In Abhängigkeit des zu behandelnden Schichtsystems können die Spalthöhe 205h und die Überlappungsbreite derart eingestellt werden, dass es zu keiner messbaren (oder einer vernachlässigbar geringen) Inhomogenität von optoelektrischen Eigenschaften in dem behandelten Schichtsystem kommt.

Wie beispielsweise in **Fig.3B** veranschaulicht ist, kann eine aus einem Bestrahlungsprozess (aus einer RTP-Behandlung) resultierende physikalische Eigenschaft, P, des Substrats 220 oder der Beschichtung auf dem Substrat 220 von der eingetragenen Energie (normiert auf die Fläche) abhängig sein. Für eine vordefinierte Schwankung (Toleranz) ΔP kann sich somit ein vordefiniertes Energieintervall ΔE für das Bestrahlen ergeben, z.B. mit einer minimalen Energie (einer Aktivierungsschwelle) Eₘᵢₙ oder mit einer minimalen Energie Eₘᵢₙ und maximalen Energie Eₘₐₓ (einem Aktivierungsfenster). In analoger Weise kann ein derartiger Zusammenhang zur Leistung oder zur maximalen Leistung bestehen. In analoger Weise kann ein Zusammenhang zwischen der Aktivierungsschwelle und/oder dem Aktivierungsfenster und dem Strahlungspuls bestehen (z.B. können die Aktivierungsschwelle und/oder das Aktivierungsfenster beim Bestrahlen, z.B. in der Intensität und/oder in der Bestrahlung, berücksichtigt werden). Ferner kann die maximalen Energie Eₘₐₓ beispielsweise dadurch definiert sein, dass keine weitere Verbesserung der zu aktivierenden Eigenschaften erfolgt, oder dass eine Verschlechterung der zu aktivierenden Eigenschaften erfolgt, und/oder dass das Substrat oder die Beschichtung zerstört oder beeinträchtigt wird (auch als Zerstörschwelle bezeichnet).

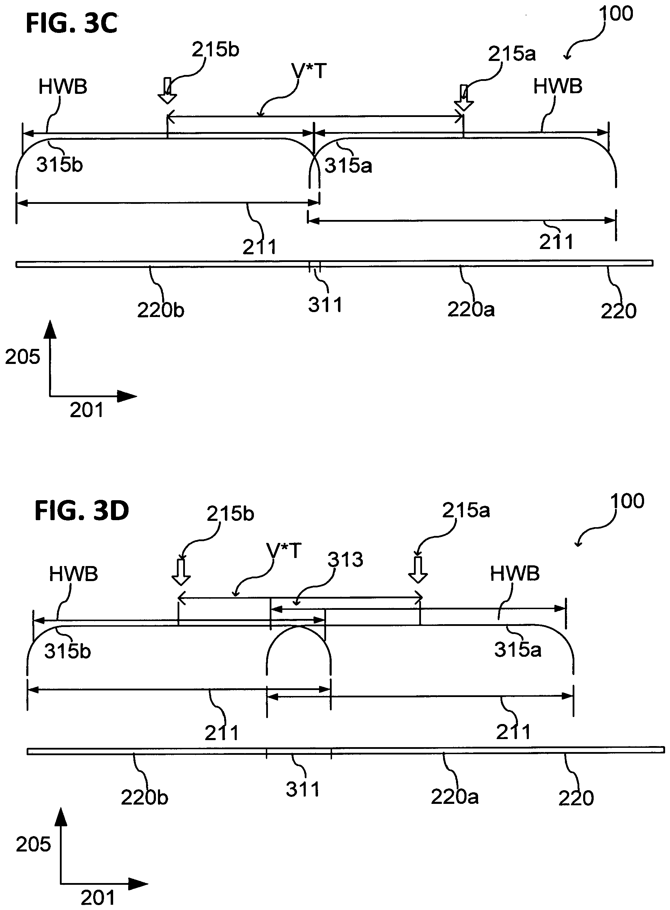

Anschaulich kann das Energieintervall einer radiometrischen Größe für das Bestrahlen entsprechen, z.B. der Bestrahlung, der Intensität oder Ähnlichem. Dies kann beispielsweise bei Einstellen der Überlappungsbreite berücksichtigt werden. Wie beispielsweise in den Figuren 3C bis 3H veranschaulicht ist.

**Fig.3C** und **Fig.3D** veranschaulichen jeweils in einer schematischen Ansicht zwei räumliche Strahlungsverteilungen 315a, 315b, welche mittels des ersten Bestrahlens 215a zu einem ersten Zeitpunkt, T₁, und mittels des zweiten Bestrahlens 215b zu einem zweiten Zeitpunkt, T₂, in das Substrat 220 eingestrahlt wurden. Zwischen dem ersten Zeitpunkt T₁ und dem zweiten Zeitpunkt T₂ hat sich das Substrat 220 mit einer Transportgeschwindigkeit, V, um V*(T₂-T₁)=V*T entlang der Transportrichtung weiter bewegt. Die räumlichen Strahlungsverteilungen 315a, 315b können als räumliche Verteilungen der Bestrahlung (oder auch als räumliche Verteilungen der Intensität oder als räumliche Verteilungen der Bestrahlungsstärke) verstanden werden, mit der das Substrat 220 beim ersten Bestrahlen 215a und beim zweiten Bestrahlen 215b bestrahlt wurde. Mit anderen Worten kann die in dem Bestrahlungsbereich bereitgestellte räumliche Strahlungsverteilungen 315 (vgl. beispielsweise Fig.3A) lediglich auf dem Substrat 220 gegeneinander verschoben eingestrahlt werden.

Die zwei auf das Substrat 220 eingestrahlten räumlichen Bestrahlungsverteilungen 315a, 315b können jeweils ein Maximum aufweisen, z.B. ein Plateau, welches ein Maximum definiert, wie vorangehend beschrieben ist, und eine räumliche Halbwertsbreite, HWB, wobei der zeitliche Abstand, T=(T₂-T₁), des ersten Bestrahlens 215a und des zweiten Bestrahlens 215b ungefähr HWB/V ist. Somit können die Bereiche 220a, 220b des Substrats 220 beispielsweise genau einmal mit einer Bestrahlung (J/cm²) von größer als 50% des Maximums der Bestrahlung bzw. genau einmal mit einer Intensität (W/mm²) von größer als 50% des Maximums der Intensität bestrahlt werden.

Anschaulich können die Randbereiche der räumlichen Strahlungsverteilungen 315 mit zu geringer Intensität (weniger als 50 % des Maximums der Intensität) und somit einer zu geringen Bestrahlung (weniger als 50 % des Maximums der Bestrahlung), z.B. gemessen pro Bestrahlen 215a, 215b, auf dem Substrat 220 überlappt werden. Anschaulich kann sich beispielsweise für die Intensität und die Bestrahlung eine ähnliche räumliche Verteilung pro Bestrahlen 215a, 215b ergeben, wobei sich in dem Überlappungsbereich 311 auf dem Substrat 220 die erste Bestrahlungsverteilung 315a des ersten Bestrahlens 215a und die zweite Bestrahlungsverteilung 315b des zweiten Bestrahlens 215b addieren.

Gemäß verschiedenen Ausführungsformen kann das Maximum (die maximale Bestrahlung) der in das Substrat 220 eingestrahlten räumlichen Bestrahlungsverteilungen 315a, 315b in einem Bereich von ungefähr 1 J/cm² bis ungefähr 25 J/cm² pro Bestrahlen 215a, 215b liegen. Dabei kann sich die gesamte Bestrahlung des Substrats jeweils aus der räumlichen Intensitätsverteilung des ersten Bestrahlens 215a sowie des zweiten Bestrahlens 215b integriert über die Zeitdauer des jeweiligen Bestrahlens 215a, 215b ergeben.

Aufgrund der Überlappung 311 der in das Substrat 220 eingestrahlten räumlichen Bestrahlungsverteilungen 315a, 315b wird ein Bereich 311 des Substrats 220 doppelt bestrahlt, wobei allerdings die Bestrahlung pro Bestrahlen weniger als 50% ist verglichen mit den einmal bestrahlten Bereichen 220a, 220b des Substrats 220. Somit kann sich im Wesentlichen in Addition der beiden in das Substrat 220 eingestrahlten räumlichen Bestrahlungsverteilungen 315a, 315b eine homogene Bestrahlungsverteilung entlang der Transportrichtung 201 für das gesamte Substrat 220 ergeben.

Anschaulich kann die räumliche Halbwertsbreite, HWB, einen effektiven Bestrahlungsbereich mit einer effektiven Bestrahlungsbereichslänge, welche der räumliche Halbwertsbreite entspricht, definieren, wobei das Substrat 220 derart mit der Transportgeschwindigkeit V bewegt und bestrahlt wird, dass das Bestrahlen unter Berücksichtigung der effektiven Bestrahlungsbereichslänge erfolgt.

Wie in Fig.3D veranschaulicht ist, kann der Überlappungsbereich 311 auf dem Substrat 220 auch größer eingestellt werden, z.B. indem die Transportgeschwindigkeit, V, verkleinert wird und/oder indem der Zeitabstand, T, zwischen dem ersten und dem zweiten Bestrahlen 215a, 215b verkürzt wird. Anschaulich kann das Bestrahlen unter Berücksichtigung der effektiven Bestrahlungsbereichslänge erfolgen, wobei diese auf dem Substrat überlappt wird 313.

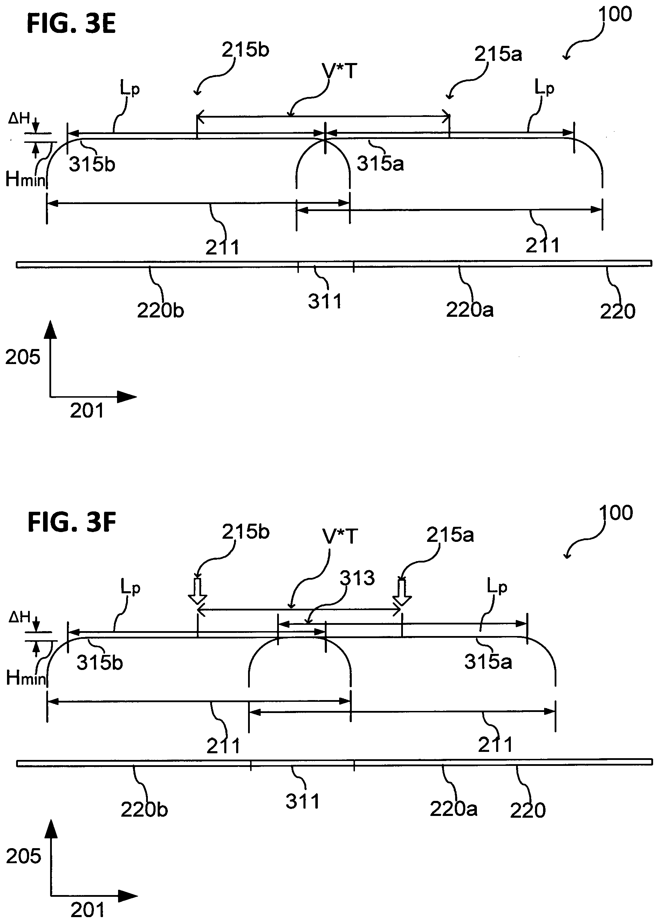

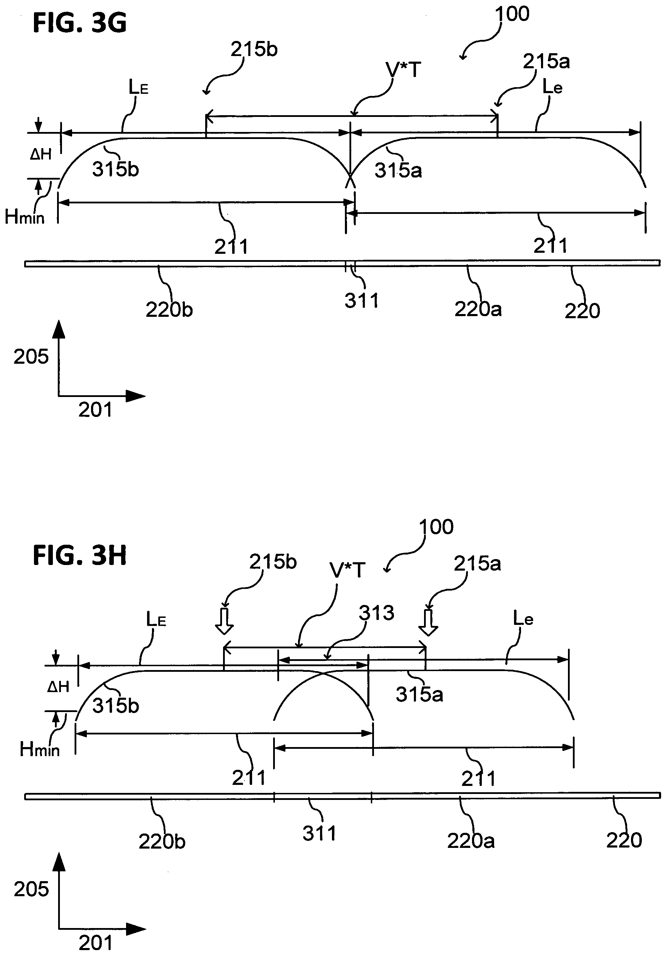

In analoger Weise kann der effektive Bestrahlungsbereich mit einer effektiven Bestrahlungsbereichslänge dadurch definiert sein, dass die räumliche Strahlungsverteilung 315 Randbereiche und einen Plateaubereich aufweist, vgl. Fig.3A, mit einer Plateaulänge, L_{P}, wobei der Plateaubereich anstatt mit der räumlichen Halbwertsbreite der räumlichen Strahlungsverteilung 315 mit einem anderen Kriterium ermittelt wird, wie beispielsweise in **Fig.3E** und **Fig.3F** für ein Kriterium von 90% des Maximums der räumlichen Strahlungsverteilung 315 veranschaulicht ist und in **Fig.3G** und **Fig.3H** für eine Kriterium von 10% des Maximums der räumlichen Strahlungsverteilung 315.

Diese Kriterien können sich beispielsweise wie in Fig.3B veranschaulicht, aus der minimalen Energie, Eₘᵢₙ, oder aus dem Energieintervall, ΔE, ergeben, welches beispielsweise in einer minimalen Intensität, Iₘᵢₙ, für das Bestrahlen resultiert, was beim Transportieren und Bestrahlen des Substrats 220 berücksichtigt sein kann. Beispielsweise aus der minimalen Energie, Eₘᵢₙ, oder aus dem Energieintervall, ΔE, eine minimale Bestrahlung, Hₘᵢₙ, bzw. ein Bestrahlungsintervall, ΔH, resultieren, was beim Transportieren und Bestrahlen des Substrats 220 berücksichtigt sein kann. Anschaulich kann ein zu bestrahlendes Material mit einem schmalen Aktivierungsfenster ΔH (bzw. ΔE, vgl. Fig.3B) eine größere Überlappung benötigen, z.B. so dass ungefähr die Plateaubereiche mit H > Hₘᵢₙ und Hₘᵢₙ=90% Hₘₐₓ aneinandergrenzen, wobei ein Material mit einem breiten Aktivierungsfenster ΔH (bzw. ΔE, vgl. Fig.3B) kann eine geringere Überlappung benötigen, z.B. so dass ungefähr die effektive Bestrahlungsbereiche der Länge L_{E} mit H > Hₘᵢₙ und Hₘᵢₙ=10% Hₘₐₓ aneinandergrenzen.

**Fig.3E** und **Fig.3F** veranschaulichen jeweils in einer schematischen Ansicht zwei räumliche Strahlungsverteilungen 315a, 315b, welche mittels des ersten Bestrahlens 215a zu einem ersten Zeitpunkt, T₁, und mittels des zweiten Bestrahlens 215b zu einem zweiten Zeitpunkt, T₂, in das Substrat 220 eingestrahlt wurden. Zwischen dem ersten Zeitpunkt T₁ und dem zweiten Zeitpunkt T₂ hat sich das Substrat 220 mit einer Transportgeschwindigkeit, V, um V*(T₂-T₁)=V*T entlang der Transportrichtung 201 weiter bewegt. Die räumlichen Strahlungsverteilungen 315a, 315b können als räumliche Verteilungen der Bestrahlung (oder auch als räumliche Verteilungen der Intensität oder als räumliche Verteilungen der Bestrahlungsstärke) verstanden werden, mit der das Substrat beim ersten Bestrahlen 215a und beim zweiten Bestrahlen 215b bestrahlt wurde. Mit anderen Worten kann die in dem Bestrahlungsbereich bereitgestellte räumliche Strahlungsverteilungen 315 (vgl. beispielsweise Fig.3A) lediglich auf dem Substrat gegeneinander verschoben eingestrahlt werden.

Die zwei auf das Substrat 220 eingestrahlten räumlichen Bestrahlungsverteilungen 315a, 315b können jeweils ein Plateau mit einer Plateaulänge, L_{P}, aufweisen, wie vorangehend beschrieben ist, wobei der zeitliche Abstand, T=(T₂-T₁), des ersten Bestrahlens 215a und des zweiten Bestrahlens 215b ungefähr L_{P}/V ist. Somit können die Bereiche 220a, 220b des Substrats 220 beispielsweise genau einmal mit einer Bestrahlung (J/cm²) von größer als 50% des Maximums der Bestrahlung bzw. genau einmal mit einer Intensität (W/mm²) von größer als 50% des Maximums der Intensität bestrahlt werden.

Anschaulich können die Randbereiche der räumlichen Strahlungsverteilungen 315 mit zu geringer Intensität (weniger als 90 % des Maximums der Intensität) und somit einer zu geringen Bestrahlung (weniger als 90 % des Maximums der Bestrahlung), z.B. gemessen pro Bestrahlen 215a, 215b, überlappt werden. Anschaulich kann sich beispielsweise für die Intensität und die Bestrahlung eine ähnliche räumliche Verteilung pro Bestrahlen 215a, 215b ergeben, wobei sich in dem Überlappungsbereich 311 auf dem Substrat 220 die erste Bestrahlungsverteilung 315a des ersten Bestrahlens 215a und die zweite Bestrahlungsverteilung 315b des zweiten Bestrahlens 215b addieren.

Gemäß verschiedenen Ausführungsformen kann das Maximum (die maximale Bestrahlung) der in das Substrat 220 eingestrahlten räumlichen Bestrahlungsverteilungen 315a, 315b in einem Bereich von ungefähr 1 J/cm² bis ungefähr 25 J/cm² pro Bestrahlen 215a, 215b liegen. Dabei kann sich die gesamte Bestrahlung auf dem Substrat 220 aus der räumlichen Intensitätsverteilung des ersten Bestrahlens 215a sowie des zweiten Bestrahlens 215b integriert über die Zeitdauer des jeweiligen Bestrahlens 215a, 215b ergeben.

Beispielsweise kann die Bestrahlung in einem Bereich von ungefähr 1 J/cm² bis ungefähr 25 J/cm², in einem Bereich von ungefähr z.B. 1 J/cm² bis ungefähr 10 J/cm^{2,} in einem Bereich von ungefähr z.B. 4 J/cm² bis ungefähr 9 J/cm², liegen, wobei die Bestrahlung in der Substratebene bei einer Bestrahlungsdauer von ungefähr 300 µs gemessen wird.

Aufgrund der Überlappung 311 der in das Substrat 220 eingestrahlten räumlichen Bestrahlungsverteilungen 315a, 315b wird ein Bereich 311 des Substrats 220 doppelt bestrahlt, wobei die Bestrahlung pro Bestrahlen weniger als 90% ist verglichen mit den einmal bestrahlten Bereichen 220a, 220b des Substrats 220. Somit kann sich in Addition der beiden in das Substrat 220 eingestrahlten räumlichen Bestrahlungsverteilungen 315a, 315b eine inhomogene Bestrahlungsverteilung entlang der Transportrichtung 201 für das gesamte Substrat 220 ergeben. Allerdings kann es für ein Substrat oder für eine Beschichtung ausreichend sein, mindestens einmal mit einer Intensität von mehr als 90 % des Maximums der Intensität bestrahlt zu werden.

Anschaulich kann das Substrat 220 derart mit der Transportgeschwindigkeit V bewegt und derart bestrahlt werden, dass das Bestrahlen unter Berücksichtigung der Plateaulänge erfolgt. Wie in Fig.3F veranschaulicht ist, kann der Überlappungsbereich 311 auf dem Substrat 220 auch größer eingestellt werden, z.B. indem die Transportgeschwindigkeit, V, verkleinert wird und/oder indem der Zeitabstand, T, zwischen dem ersten und dem zweiten Bestrahlen 215a, 215b verkürzt wird. Anschaulich kann das Bestrahlen unter Berücksichtigung der Plateaulänge erfolgen, wobei diese auf dem Substrat überlappt wird 313.

**Fig.3G** und **Fig.3H** veranschaulichen jeweils in einer schematischen Ansicht zwei räumliche Strahlungsverteilungen 315a, 315b, welche mittels des ersten Bestrahlens 215a zu einem ersten Zeitpunkt, T₁, und mittels des zweiten Bestrahlens 215b zu einem zweiten Zeitpunkt, T₂, in das Substrat 220 eingestrahlt wurden. Zwischen dem ersten Zeitpunkt T₁ und dem zweiten Zeitpunkt T₂ hat sich das Substrat 220 mit einer Transportgeschwindigkeit, V, um V*(T₂-T₁)=V*T entlang der Transportrichtung 201 weiter bewegt. Die räumlichen Strahlungsverteilungen 315a, 315b können als räumliche Verteilungen der Bestrahlung (oder auch als räumliche Verteilungen der Intensität oder als räumliche Verteilungen der Bestrahlungsstärke) verstanden werden, mit der das Substrat beim ersten Bestrahlen 215a und beim zweiten Bestrahlen 215b bestrahlt wurde. Mit anderen Worten kann die in dem Bestrahlungsbereich bereitgestellte räumliche Strahlungsverteilungen 315 (vgl. beispielsweise Fig.3A) lediglich auf dem Substrat gegeneinander verschoben eingestrahlt werden.

Die zwei auf das Substrat 220 eingestrahlten räumlichen Bestrahlungsverteilungen 315a, 315b können jeweils eine effektive Bestrahlungsbereichslänge, L_{E}, aufweisen, wie vorangehend beschrieben ist, wobei der zeitliche Abstand, T=(T₂-T₁), des ersten Bestrahlens 215a und des zweiten Bestrahlens 215b ungefähr L_{E}/V ist. Somit können die Bereiche 220a, 220b des Substrats 220 beispielsweise genau einmal mit einer Bestrahlung (J/cm²) von größer als 10% des Maximums der Bestrahlung bzw. genau einmal mit einer Intensität (W/mm²) von größer als 10% des Maximums der Intensität bestrahlt werden.

Anschaulich können die Randbereiche der räumlichen Strahlungsverteilungen 315 mit zu geringer Intensität (weniger als 10 % des Maximums der Intensität) und somit einer zu geringen Bestrahlung (weniger als 10 % des Maximums der Bestrahlung), z.B. gemessen pro Bestrahlen 215a, 215b, überlappt werden. Anschaulich kann sich beispielsweise für die Intensität und die Bestrahlung eine ähnliche räumliche Verteilung pro Bestrahlen 215a, 215b ergeben, wobei sich in dem Überlappungsbereich 311 auf dem Substrat 220 die erste Bestrahlungsverteilung 315a des ersten Bestrahlens 215a und die zweite Bestrahlungsverteilung 315b des zweiten Bestrahlens 215b addieren.

Gemäß verschiedenen Ausführungsformen kann das Maximum (die maximale Bestrahlung) der in das Substrat 220 eingestrahlten räumlichen Bestrahlungsverteilungen 315a, 315b in einem Bereich von ungefähr 1 J/cm² bis ungefähr 25 J/cm² pro Bestrahlen 215a, 215b liegen. Dabei kann sich die gesamte Bestrahlungsverteilung auf dem Substrat 220 aus der räumlichen Intensitätsverteilung des ersten Bestrahlens 215a sowie des zweiten Bestrahlens 215b integriert über die Zeitdauer des jeweiligen Bestrahlens 215a, 215b ergeben.

Aufgrund der Überlappung 311 der in das Substrat 220 eingestrahlten räumlichen Bestrahlungsverteilungen 315a, 315b wird ein Bereich 311 des Substrats 220 doppelt bestrahlt, wobei die Bestrahlung pro Bestrahlen weniger als 10% ist verglichen mit den einmal bestrahlten Bereichen 220a, 220b des Substrats 220. Somit kann sich in Addition der beiden in das Substrat 220 eingestrahlten räumlichen Bestrahlungsverteilungen 315a, 315b eine inhomogene Bestrahlungsverteilung entlang der Transportrichtung 201 für das gesamte Substrat 220 ergeben. Allerdings kann es für ein Substrat oder für eine Beschichtung ausreichend sein, mindestens einmal mit einer Intensität von mehr als 10 % des Maximums der Intensität bestrahlt zu werden. Anschaulich kann das Substrat 220 derart mit der Transportgeschwindigkeit V bewegt und derart bestrahlt werden, dass das Bestrahlen unter Berücksichtigung der effektiven Bestrahlungsbereichslänge erfolgt.

Wie in Fig.3H veranschaulicht ist, kann der Überlappungsbereich 311 auf dem Substrat 220 auch größer eingestellt werden, z.B. indem die Transportgeschwindigkeit, V, verkleinert wird und/oder indem der Zeitabstand, T, zwischen dem ersten und dem zweiten Bestrahlen 215a, 215b verkürzt wird. Anschaulich kann das Bestrahlen unter Berücksichtigung der effektiven Bestrahlungsbereichslänge erfolgen, wobei diese auf dem Substrat überlappt wird 313.

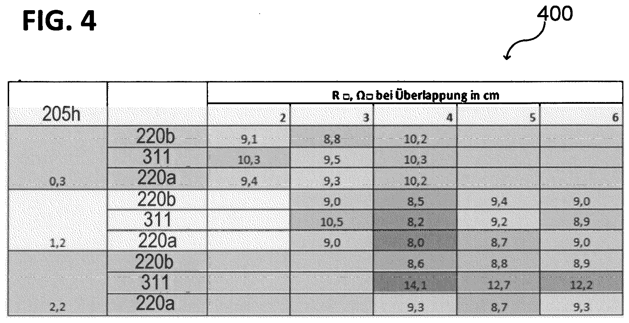

**Fig.4** veranschaulicht, am Beispiel eines ZAO-Schichtsystems (z.B. einer low-E Beschichtung aufweisend aluminiumdotiertes Zinkoxid), eine tabellarische Übersicht des elektrischen Widerstands, R, des ZAO-Schichtsystems für verschiedene Bereiche 220a, 220b, 311 des Substrats 220 bei verschiedenen Überlappungen in Abhängigkeit von der Spalthöhe 205h zwischen Substrat 220 und Blendenstruktur 206a, 206b nachdem das Substrat 220 gemäß dem Verfahren 100 und/oder mittels der Prozesskammeranordnung 200 bestrahlt wurde, wie vorangehend beschrieben.

Dabei ist für jeweils den ersten genau einmal belichteten Bereich 220a des Substrats 220, den zweiten genau einmal belichteten Bereich 220b des Substrats 220 und für den Überlappungsbereich 311 des Substrats 220 der elektrische Flächenwiderstand in Ohm für verschiedene Spalthöhen 205h in Zentimetern bei der jeweiligen Überlappung in Zentimetern angegeben.

Wie beispielhaft in Fig.4 veranschaulicht ist, kann bei einer Spalthöhe von beispielsweise 22 mm keine Überlappung gefunden werden, bei der ein ausreichend homogener Flächenwiderstand für das ZAO-Schichtsystem für alle Bereiche 220a, 220b, 311 auf dem Substrat 220 erzeugt werden kann. Im Gegensatz dazu kann bei einer Spalthöhe 205h von weniger als 22 mm, z.B. 12 mm oder 3 mm, mit einer Überlappung von ungefähr 4 cm ein homogener Flächenwiderstand für das ZAO-Schichtsystem für alle Bereiche 220a, 220b, 311 auf dem Substrat 220 erzeugt werden, z.B. mit einem Widerstand im Bereich von 8,0 Ω bis 8,5 Ω bei einer Spalthöhe 205h von 12 mm (d.h. mit einer Schwankung des Widerstands von weniger als 10%) und z.B. mit einem Widerstand im Bereich von 10,2 Ω bis 10,3 Ω bei einer Spalthöhe 205h von 3 mm (d.h. mit einer Schwankung des Widerstands von weniger als 10%, z.B. weniger als 5%, z.B. ungefähr 1%).

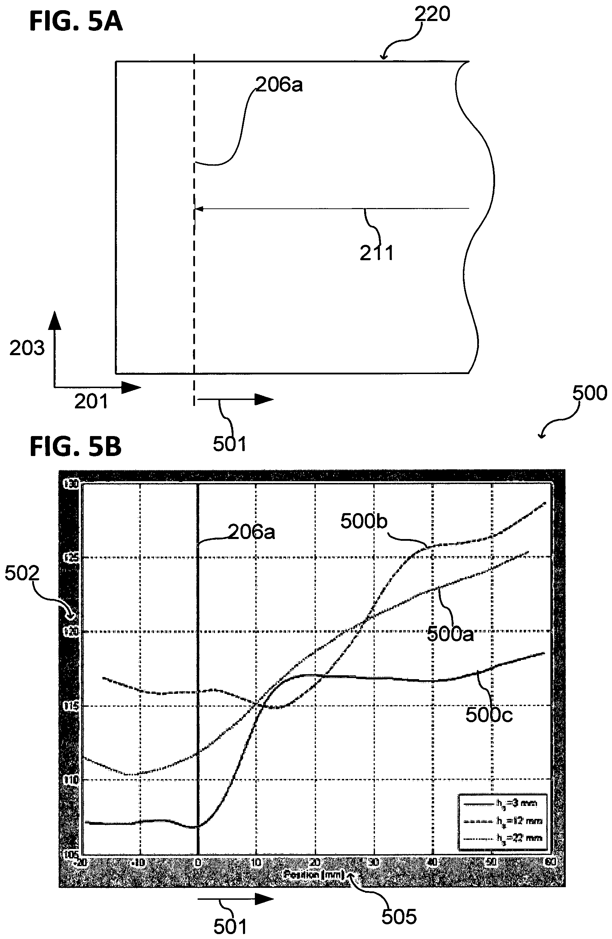

Ferner wurde für bereichsweise einfachbestrahlte (einfachbelichtete) Proben erkannt, z.B. veranschaulicht am Beispiel des ZAO-Schichtsystems, wie in **Fig.5A** und **Fig.5B** veranschaulicht, dass sich das ZAO-Schichtsystem im Bereich der reduzierten Beleuchtungsstärke (in den Randbereichen) auch voraktivieren lässt.

In Fig.5B ist eine räumliche Verteilung des Farbwertes 502 (ermittelt aus RGB) bzw. die Illuminanz eines abschnittsweise einfachbestrahlten Substrats 220 entlang der Längsrichtung 501 des bestrahlten Substrats 220 veranschaulicht, d.h. entlang der Position 505 relativ zu der Position des ersten Seitenreflektors 206a beim Bestrahlen, was in Fig.5A in einer Draufsicht auf das Substrat 220 veranschaulicht ist. Dabei ist die Spalthöhe 205h (in Fig. 5B mit h_{S} bezeichnet) berücksichtigt, wobei der Graph 500a einer Bestrahlung bei einer Spalthöhe 205h von ungefähr 22 mm, der Graph 500b einer Bestrahlung bei einer Spalthöhe 205h von ungefähr 12 mm und der Graph 500c einer Bestrahlung bei einer Spalthöhe 205h von ungefähr 3 mm veranschaulicht.

Dabei entsprechen die Breiten, in der die Illuminanz von einem Niveau zu anderen wechselt, auch den erforderlichen Überlappungsbreiten, die sich aus den in Fig.4 veranschaulichten Messungen ergeben. Durch diese Voraktivierung lässt sich auch die erforderliche Überlappungsbreite reduzieren. Bei Schichtsystemen mit einem schmalen Aktivierungsfenster (ΔE, ΔI oder ΔH, wie vorangehend beschrieben) vergrößert sich dagegen die Überlappungsbreite bis auf das doppelte der Breite, in dem die Beleuchtungsstärke abfällt (vgl. z.B. Fig.3E).

Anschaulich kann bei einer Spalthöhe 205h von ungefähr 22 mm oder von mehr als ungefähr 22 mm keine Stufe in der Illuminanz festgestellt werden, so dass daraus ein Überlappen zu einer homogenen Illuminanz mittels zweier Bestrahlungen auch für große Überlappungen von 6 cm oder mehr als 6 cm nicht möglich sein kann, wie analog für den elektrischen Widerstand in Fig.4 dargestellt ist.

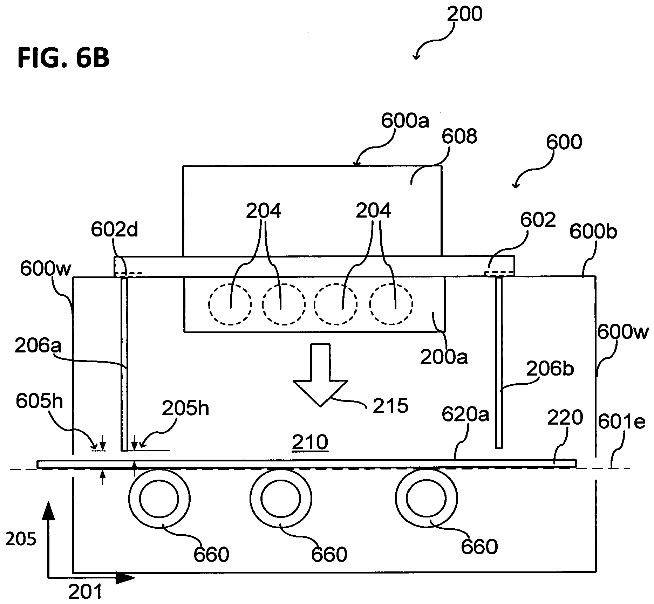

In den folgenden Figuren ist jeweils eine Prozesskammeranordnung 200 in einer schematischen Seitenansicht oder Querschnittsansicht dargestellt, gemäß verschiedenen Ausführungsformen. Die Prozesskammeranordnung 200 kann eine oder mehrere Vakuumkammer aufweisen (auch als Vakuumprozessieranlage bezeichnet), so dass das Substrat beispielsweise im Vakuum bestrahlt werden kann, wie vorangehend beschrieben ist. Ferner kann die Prozesskammeranordnung 200 mindestens eine Bestrahlungskammer 600 aufweisen, wie beispielsweise in Fig.6A, Fig.6B und Fig.7 veranschaulicht ist, sowie zusätzlich mindestens eins von Folgenden: eine Beschichtungskammer zum Beschichten des Substrats (z.B. mittels Sputterdeposition, Elektronenstrahlverdampfens oder thermischen Verdampfens), eine Reinigungskammer zum Reinigen des Substrats, eine Abkühlkammer und/oder Heizkammer zum Temperieren des Substrats, eine Ätzkammer zum teilweisen Entfernen einer Beschichtung auf dem Substrat oder zum Strukturieren des Substrats, eine Schleusenkammer zum Einschleusen und/oder Ausschleusen des Substrats aus der Prozesskammeranordnung 200, eine Pufferkammer zum Vorhalten eines Substrats, eine Transferkammer zum Bilden eines Substratbands (Endlossubstrats) aus schubweise eingeschleusten Substraten und/oder zum Vereinzeln eines Substratbands zu mehreren einzelnen Substraten zum schubweisen Ausschleusen der Substrate, und Ähnliches.

Ferner kann die Prozesskammeranordnung 200 eine Transportvorrichtung aufweisen zum Transportieren von mindestens einem Substrat in die mindestens eine Vakuumkammer (beispielsweise die mindestens eine Bestrahlungskammer 600) der Prozesskammeranordnung 200 hinein, aus der mindestens einen Vakuumkammer der Prozesskammeranordnung 200 heraus und/oder durch die mindestens eine Vakuumkammer der Prozesskammeranordnung 200 hindurch. Dabei kann die Transportvorrichtung an das jeweils zu transportierende Substrat 220 angepasst sein, so dass beispielsweise plattenförmige Substrate, wie Glasscheiben oder Wafer, oder andere plattenförmige Träger mittels der Prozesskammeranordnung 200 prozessiert werden können oder so dass bandförmige Substrate, wie Folien oder Metallbänder, mittels der Prozesskammeranordnung 200 prozessiert werden können. Zum Transportieren plattenförmiger Substrate kann die Transportvorrichtung beispielsweise ein Transportrollensystem mit einer Vielzahl von Transportrollen 660 aufweisen, auf welchen die plattenförmigen Substrate 220 in einer Transportfläche 601e (z.B. einer planaren Transportebene 601e) durch die Vakuumkammer (z.B. die mindestens eine Bestrahlungskammer 600) der Prozesskammeranordnung 200 hindurch geführt werden können.

Zum Transportieren eines bandförmigen Substrats kann die Transportvorrichtung beispielsweise mindestens zwei Wickelrollen (oder Walzen) aufweisen, mittels derer das bandförmige Substrat von Rolle-zu-Rolle in einer Transportfläche (einer planaren oder gekrümmten Transportebene) durch die Vakuumkammer (z.B. mindestens eine Bestrahlungskammer) hindurch geführt werden kann. Wenn ein bandförmiges Substrat auf beispielsweise einer Transporttrommel aufliegend in der Bestrahlungskammer 600 entlang einer gekrümmten Transportfläche (z.B. entlang der Mantelfläche der Transporttrommel) transportiert wird, ergibt sich die Transportgeschwindigkeit V des Substrats aus der Rotationsgeschwindigkeit der Transporttrommel und dem Radius der Transporttrommel (auch bezeichnet als Bahngeschwindigkeit). Anschaulich kann das Substrat entlang einer beliebig geeigneten Bahnkurve bewegt werden, z.B. entlang einer Kreisbahn oder auch zumindest teilweise freihängen, wobei die Transportgeschwindigkeit V des Substrats dann der Bahngeschwindigkeit entspricht.

Gemäß verschiedenen Ausführungsformen kann mittels einer Vakuumkammer ein Vakuum (z.B. mit einem Druck von weniger als 1 mbar) bereitgestellt sein oder werden. Ferner kann auch mittels mehrerer miteinander gekoppelter Vakuumkammern ein gemeinsames Vakuumsystem bereitgestellt sein oder werden. Eine Vakuumkammer kann beispielsweise in mehrere Kammern, Sektionen bzw. Kompartments unterteilt sein. Ferner kann eine Vakuumkammer modular aufgebaut sein, so dass mehrere der modularen Vakuumkammern zu einer gemeinsamen größeren Vakuumkammer gekoppelt werden können. Ferner kann eine Vakuumkammer ein Kammergehäuse mit einer Deckelöffnung aufweisen sowie einen Kammerdeckel zum vakuumdichten Abdecken der Deckelöffnung, wie beispielsweise in Fig.6A und 6B veranschaulicht ist. Ein Kammergehäuse kann beispielsweise, analog zur Vakuumkammer, in mehrere Kammern, Sektionen bzw. Kompartments unterteilt sein. Ferner kann ein Kammergehäuse modular aufgebaut sein, so dass mehrere der modularen Kammergehäuse zu einem gemeinsamen größeren Kammergehäuse gekoppelt werden können.

Verschiedene Kammern (Sektionen oder Kompartments) einer Vakuumkammer oder eines Kammergehäuses (oder einer Vakuumprozessieranlage) können beispielsweise mittels so genannter Kammerwände oder Schottwände voneinander getrennt sein, beispielsweise bei einer horizontalen Durchlauf-Beschichtungsanlage (In-Line-Anlage) mittels vertikaler Kammerwände bzw. vertikaler Schottwände. Dabei kann jede Kammerwand (oder Schottwand) eine Substrat-Transferöffnung (einen Substrat-Transferspalt) derart aufweisen, dass ein Substrat durch die Kammerwand hindurch transportiert werden kann, z.B. von einer ersten Kammer einer Vakuumkammer in eine zweite Kammer einer Vakuumkammer oder z.B. von einem ersten Bereich einer Vakuumkammer in einen zweiten Bereich der Vakuumkammer. Gemäß verschiedenen Ausführungsformen kann eine Vakuumkammer einen gegenüber dem normalen Atmosphärendruck abgedichteten Innenraum bereitstellen. Dazu kann die Vakuumkammer ein entsprechend stabil eingerichtetes Kammergehäuse bzw. entsprechend stabil eingerichtete Kammerwände aufweisen.

Fig.6A veranschaulicht eine Prozesskammeranordnung 200 bzw. eine Bestrahlungskammer einer Prozesskammeranordnung 200 in einer schematischen Querschnittsansicht, gemäß verschiedenen Ausführungsformen, mittels derer Substrate 220, wie beispielsweise Wafer, Glassubstrate, oder Werkstücke, einer Temperaturbehandlung und/oder einer Lichtbehandlung unterzogen werden können. Die Bestrahlungskammer 600 kann ein Kammergehäuse 600b und einen Kammerdeckel 602 zum Abdecken einer entsprechenden Öffnung in dem Kammergehäuse 600b aufweisen. An dem Kammerdeckel 602 kann eine Blitzlampenanordnung 200a montiert sein oder die Blitzlampenanordnung 200a kann zumindest teilweise in den Kammerdeckel 602 integriert sein. Dabei kann der Kammerdeckel 602 Dichtungsbereiche 602d aufweisen, so dass der Kammerdeckel 602 auf dem Kammergehäuse aufliegend die Öffnung in dem Kammergehäuse 600b vakuumdicht verschließen kann. Anschaulich können der Kammerdeckel 602 und die Blitzlampenanordnung 200a ein Blitzlampenmodul 600a bilden, welches auf ein Kammergehäuse 600b mit einer entsprechenden Deckelöffnung aufgesetzt werden kann.

Mittels der Blitzlampen 204 der Blitzlampenanordnung 200a kann ein zu behandelndes Substrat 200 beispielsweise ausschließlich erwärmt werden, oder die chemischen und/oder physikalischen Eigenschaften des zu behandelnden Substrats 220 können verändert werden. Mittels der Blitzlampen 204 der Blitzlampenanordnung 200a können beispielsweise derart hohe Strahlungsleistungen erzeugt werden, dass ein so genannter RTP-Prozess (engl. rapid thermal processing, RTP) zum Behandeln des Substrats 220 mittels elektromagnetischer Strahlung (z.B. Licht) durchgeführt werden können. Ferner kann mittels Blitzlampen 204 der Blitzlampenanordnung 200a eine UV-Behandlung (z.B. Strahlenhärtung oder UV-Härtung) des Substrats 220 durchgeführt werden. Anschaulich kann ein Blitzlampenmodul 600a bereitgestellt sein oder werden, welches in eine Beschichtungsanlage (z.B. in eine Glasbeschichtungsanlage oder Folienbeschichtungsanlage) integriert werden kann.

Gemäß verschiedenen Ausführungsformen kann das Blitzlampenmodul 600a ein oder mehrere Blitzlampenschwingkreise aufweisen, z.B. montiert auf oder an dem Deckel 602 des Blitzlampenmodul (auf der Prozesskammerabdeckung der Prozesskammerabdeck-Anordnung), so dass die mindestens eine Blitzlampe 204 (oder die mehreren Blitzlampen) effizient betrieben werden kann, z.B. mit möglichst geringer Verlustleistung. Gemäß verschiedenen Ausführungsformen können der Ladekondensator und die Induktivität des jeweiligen Schwingkreises für eine Blitzlampe auf, an oder in dem Deckel montiert sein oder werden, z.B. in das Blitzlampenmodul 600a integriert sein oder werden. Die Stromversorgung für den jeweiligen Blitzlampenschwingkreis hingegen, von welcher nur Ströme im Bereich von wenigen Ampere pro Blitzlampe zum Ladekondensator fließen, kann an einer beliebigen Stelle räumlich entfernt von dem Blitzlampenmodul installiert sein oder werden. Alternativ kann die Blitzlampenanordnung 200a von extern versorgt werden, z.B. mittels eines oder mehrerer Blitzlampenschwingkreise, welche beispielsweise in einem Versorgungsbereich neben der Bestrahlungskammer 600 bereitgestellt sein können.

Gemäß verschiedenen Ausführungsformen können mehrere Blitzlampen 204 in der Blitzlampenanordnung 200a jeweils als austauschbares Wechselbauteil bereitgestellt sein oder werden. Anschaulich können mehrere Blitzlampen 204 gemeinsam von einem Rahmen oder Träger gehalten werden, wobei der Rahmen oder Träger lösbar an dem Kammerdeckel 602 befestig sein kann oder werden kann. Ferner können die Blitzlampen 204 jeweils einzeln lösbar an dem Rahmen oder Träger befestigt sein oder werden.

Als Blitzlampen können beispielsweise Gasentladungslampen oder Hochdruck-Gasentladungslampen genutzt werden, welche mit einer maximalen zeitlich gepulsten Leistung im Kilowatt-Bereich bis Gigawatt-Bereich betrieben werden können. Gemäß verschiedenen Ausführungsformen kann eine Blitzlampe eine elektrische Energie in einem Bereich von ungefähr 1 kJ bis ungefähr 100 kJ pro Lichtblitz umsetzten. Ferner kann eine Blitzlampe eine Lichtbogenlänge in einem Bereich von ungefähr einigen Zentimetern bis ungefähr einigen Metern aufweisen, beispielsweise in einem Bereich von ungefähr 80 cm bis ungefähr 500 cm, z.B. in einem Bereich von ungefähr 350 cm bis ungefähr 450 cm. Ferner kann mittels einer Blitzlampe eine Strahlungsenergie in einem Bereich von ungefähr 0,4 kJ bis ungefähr 100 kJ erzeugt werden, oder beispielsweise können 20 % bis 50 % der elektrischen Leistung in Strahlungsleistung umgesetzt werden, bzw. 20 % bis 50 % der elektrischen Energie können in Strahlungsenergie umgesetzt werden. Aufgrund des kurzen Lichtblitzes (z.B. im Millisekunden-Bereich) kann die Strahlungsleistung groß sein, z.B. im Gigawatt-Bereich.

Gemäß verschiedenen Ausführungsformen kann beim Blitzen mittels der Blitzlampen 204 (abhängig von der Leistung oder Leistung pro Länge) UV-Licht im Wellenlängenbereich von ungefähr 200 nm bis ungefähr 400 nm erzeugt werden, was beispielsweise zur UV-Behandlung von Substraten oder Trägern genutzt werden kann. Ferner kann beim Blitzen mittels der Blitzlampen (abhängig von der Leistung oder Leistung pro Länge) sichtbares Licht und/oder Infrarotlicht erzeugt werden.

Das Blitzlampenmodul 600a kann beispielsweise ferner mindestens einen optischen Reflektor, z.B. eine oder mehrere lichtreflektierende Flächen, aufweisen (nicht dargestellt), wobei der optische Reflektor beispielsweise zwischen den Blitzlampen 204 und dem Kammerdeckel 602 angeordnet sein kann. Mittels des optischen Reflektors kann beispielsweise die Abstrahlung 215 der Blitzlampen 204 in eine Richtung zum zu bestrahlenden Substrat 220 hin vergrößert werden. Somit kann beispielsweise ein Substrat in der Prozesskammer effizient bestrahlt werden. Ferner kann eine Erwärmung des Kammerdeckels 602 mittels des optischen Reflektors vermindert werden. Dabei kann als optischer Reflektor auch ein Reflektor im infraroten Bereich des Lichts und/oder im ultravioletten Bereich des Lichts (neben dem sichtbaren Licht) verstanden werden.

Gemäß verschiedenen Ausführungsformen kann das Blitzlampenmodul 600a eine räumliche Ausdehnung entlang der Transportrichtung 201 in einem Bereich von ungefähr 10 cm bis ungefähr 150 cm aufweisen, z.B. in einem Bereich von ungefähr 30 cm bis ungefähr 100 cm. Ferner kann das Blitzlampenmodul 600a eine räumliche Ausdehnung entlang der Richtung 203 (quer zur Richtung 201 und zur Richtung 205) in einem Bereich von ungefähr 50 cm bis ungefähr 500 cm aufweisen, z.B. in einem Bereich von ungefähr 100 cm bis ungefähr 500 cm, z.B. in einem Bereich von ungefähr 200 cm bis ungefähr 500 cm, z.B. in einem Bereich von ungefähr 100 cm bis ungefähr 450 cm, z.B. in einem Bereich von ungefähr 350 cm bis ungefähr 450 cm.

Gemäß verschiedenen Ausführungsformen kann jede der Blitzlampen 204 ein transparentes Innenrohr aufweisen (z.B. aus Quarzglas), wobei das transparente Innenrohr eine Anodenstruktur und eine Kathodenstruktur aufweist und derart eingerichtet ist (z.B. mit Gas gefüllt ist), dass innerhalb des Innenrohrs eine Gasentladung gezündet werden kann. Ferner kann jede der Blitzlampen 204 ein transparentes Außenrohr aufweisen, z.B. koaxial zum Innenrohr eingerichtet, so dass zwischen dem Innenrohr und dem Außenrohr ein Kühlmittel (z.B. Kühlwasser) geleitet werden kann.

Gemäß verschiedenen Ausführungsformen können das Innenrohr und das Außenrohr der jeweiligen Blitzlampe 204 mittels einer Lagerung gehalten werden, wobei die Lagerung eine elektrische Kontaktierung der Anode und der Kathode der jeweiligen Blitzlampe 204 ermöglichen kann, sowie das Einleiten von Kühlmittel zu der jeweiligen Blitzlampe 204 hin und das Ableiten von Kühlmittel von der jeweiligen Blitzlampe 204 weg.

Gemäß verschiedenen Ausführungsformen kann jede der Blitzlampen 204 eine Länge entlang der Richtung 203 (quer zu den Richtungen 201,205) in einem Bereich von ungefähr 50 cm bis ungefähr 500 cm aufweisen, z.B. in einem Bereich von ungefähr 100 cm bis ungefähr 500 cm, z.B. in einem Bereich von ungefähr 200 cm bis ungefähr 500 cm, z.B. in einem Bereich von ungefähr 100 cm bis ungefähr 450 cm, z.B. in einem Bereich von ungefähr 350 cm bis ungefähr 450 cm.

Gemäß verschiedenen Ausführungsformen kann jede der Blitzlampen 204 einen Durchmesser (quer zur Längserstreckung in Richtung 203) in einem Bereich von ungefähr 0,5 cm bis ungefähr 5,0 cm aufweisen, z.B. in einem Bereich von ungefähr 1,0 cm bis ungefähr 3,0 cm, z.B. in einem Bereich von ungefähr 1,5 cm bis ungefähr 2,0 cm. Gemäß verschiedenen Ausführungsformen kann jede der Blitzlampen 204 rohrförmig sein, z.B. zylindrisch oder prismatisch rohrförmig (z.B. mit einer vieleckigen Grundfläche quer zur Längserstreckung der jeweiligen Blitzlampe 106).

Ferner können die mehreren Blitzlampen 204 jeweils an deren axialen Endabschnitten mittels einer Vielzahl von Halterungen gehalten sein und an dem Kammerdeckel 602 befestigt sein. Gemäß verschiedenen Ausführungsformen kann die Blitzlampenanordnung 200a mehrere Blitzlampen 204 aufweisen, wobei die mehreren Blitzlampen 204 mittels jeweils einer Sockelstruktur an einer gemeinsamen Haltestruktur lösbar befestigt sind. Ferner kann die gemeinsame Haltestruktur eine Rahmenstruktur sein, so dass die Blitzlampenanordnung 200a als eine vormontierte Baugruppe bereitgestellt sein kann oder werden kann. Beispielsweise kann die gesamte Blitzlampenanordnung 200a als Verschleiß- oder Verbrauchsmaterial modular bereitgestellt und gewechselt werden.

Gemäß verschiedenen Ausführungsformen kann das Blitzlampenmodul 600a eine Versorgungsvorrichtung 608 aufweisen. Die Versorgungsvorrichtung 608 kann beispielsweise mindestens einen Energieversorgungsschaltkreis zum Bereitstellen von elektrischer Energie für die Blitzlampen 204. Dabei kann jeder Blitzlampe 204 jeweils genau ein Energieversorgungsschaltkreis zugeordnet sein. Die jeweilige Blitzlampe 204 kann in dem Energieversorgungsschaltkreis als Schalter fungieren, wobei in diesem Fall das Zünden der Blitzlampe 204 zusätzlich getriggert (ausgelöst) werden muss, beispielsweise mittels eines zusätzlichen elektrischen Feldes oder eines Spannungspulses, so dass in der Blitzlampe 204 eine Gasentladung erzeugt wird. Alternativ kann der Energieversorgungsschaltkreis einen oder mehrere Schalter zum Betreiben (Blitzen) der jeweiligen Blitzlampe 204 aufweisen. Die elektrischen Zuleitungen von dem mindestens einen Energieversorgungsschaltkreis zu den jeweiligen Blitzlampen 204 kann durch dem Kammerdeckel 602 hindurch verlaufen kann.

Gemäß verschiedenen Ausführungsformen kann die Versorgungsvorrichtung 608 ferner eine Kühlungsstruktur aufweisen zum thermischen Kontaktieren (z.B. zum Kühlen) der Blitzlampen 204, wobei die Kühlungsstruktur durch dem Kammerdeckel 602 hindurch verlaufen kann.

Gemäß verschiedenen Ausführungsformen kann der mindestens eine Energieversorgungsschaltkreis eine Kondensatoranordnung aufweisen mit einem Kondensator oder mit mehreren Kondensatoren (z.B. parallel geschaltet), wobei die Kondensatoranordnung allmählich aufgeladen werden kann mittels einer externen Strom-/Spannungsquelle und (zum Erzeugen des Strahlungspulses (des Lichtblitzes) mittels der Blitzlampe 204) durch die mindestens eine Blitzlampe 204 entladen werden kann. Ferner kann der mindestens eine Energieversorgungsschaltkreis eine Spulenanordnung aufweisen mit eine Spule oder mit mehreren Spulen (z.B. parallel oder in Reihe geschaltet), wobei die Spulenanordnung derart eingerichtet ist, dass diese das Entladen der Kondensatoranordnung durch die mindestens eine Blitzlampe 204 hindurch beeinflusst. Anschaulich kann jeweils eine Blitzlampe 204 oder alle Blitzlampen der Blitzlampenanordnung 200a mittels einer gepulsten Hochstromquelle betrieben werden, wobei die gepulste Hochstromquelle in das Blitzlampenmodul 600a integriert sein kann.

Gemäß verschiedenen Ausführungsformen kann der Energieversorgungsschaltkreis eine elektrische Spannung zwischen der Anode und der Kathode der jeweiligen Blitzlampe 204 bereitstellen in einem Bereich von ungefähr 1 kV bis ungefähr 40 kV, z.B. in einem Bereich von ungefähr 10 kV bis ungefähr 40 kV, z.B. in einem Bereich von ungefähr 20 kV bis ungefähr 40 kV. Ferner kann der Energieversorgungsschaltkreis einen gepulsten Maximalstrom zwischen der Anode und der Kathode der jeweiligen Blitzlampe 204 in einem Bereich von ungefähr 100 A bis ungefähr 10 kA ermöglichen, z.B. in einem Bereich von ungefähr 1 kA bis ungefähr 10 kA, z.B. in einem Bereich von ungefähr 4 kA bis ungefähr 6 kA.

Gemäß verschiedenen Ausführungsformen kann das Blitzlampenmodul derart eingerichtet sein, mehrere rohrförmige Blitzlampen 204 aufzunehmen, zu halten und/oder zu versorgen (elektrisch zu versorgen und/oder zu kühlen), z.B. zwei, drei, vier, fünf, sechs, sieben, acht, neun, zehn, oder mehr als zehn Blitzlampen, z.B. mehr als 12 Blitzlampen oder mehr als 20 Blitzlampen. Dabei können die mehreren Blitzlampen 204 nebeneinander angeordnet sein, z.B. quer zu deren Längsrichtung nebeneinander.

Fig.6A veranschaulicht die Prozesskammeranordnung 200 in geöffnetem (bzw. in offenem) Zustand, wobei der Kammerdeckel 602 (bzw. das Blitzlampenmodul 600a) von dem Kammergehäuse 600b abgehoben ist oder noch nicht auf dem Kammergehäuse 600b aufgelegt ist.

Fig.6B veranschaulicht die Prozesskammer-Anordnung 200 in einer schematischen Seitenansicht, gemäß verschiedenen Ausführungsformen, wobei der Kammerdeckel 602 (bzw. das Blitzlampenmodul 600a) an das Kammergehäuse 600b montiert ist. In Fig.6B ist die bezüglich Fig.6A beschriebene Prozesskammeranordnung 200 in geschlossenem Zustand veranschaulicht, z.B. nachdem der Kammerdeckel 602 (bzw. das Blitzlampenmodul 600a) auf das Kammergehäuse 600b aufgelegt wurde. Dabei kann der Kammerdeckel 602 mit dessen Auflagefläche 602d oder Dichtfläche 602d auf der passenden Auflagefläche oder Dichtfläche des Kammergehäuses 600b aufliegen oder angrenzen. Somit kann der Bereich zwischen dem Kammergehäuse 600b (oder oberen Kammerwand) und dem Kammerdeckel 602 vakuumdicht oder luftdicht abgedichtet sein oder werden. Es versteht sich, dass die Öffnung in dem Kammergehäuse 600b (oder in einer Kammerwand des Kammergehäuses 600b) passend zur Blitzlampenanordnung 200a bereitgestellt sein kann, so dass sich diese zumindest teilweise in das Kammergehäuse 600b hinein erstrecken kann. Ferner kann der Bereich zwischen dem Kammergehäuse 600b (oder und dem Kammerdeckel 602 mittels einer elastischen Dichtung abgedichtet sein oder werden.

Im montierten Zustand kann der Kammerdeckel 602 bzw. das Blitzlampenmodul 600a formschlüssig auf dem Kammergehäuse 600b aufliegen, wobei mindestens eine Blitzlampe 204 innerhalb des Kammergehäuses 600b gehalten wird, so dass ein Substrat 220 in einem Bestrahlungsbereich 210 mittels der mindestens einen Blitzlampe 204 bestrahlt werden kann. Dabei kann das Substrat 220 beispielsweise entlang einer planaren (oder auch gekrümmten) Transportfläche 601 e mit einer Transportgeschwindigkeit, V, geführt werden, z.B. mittels einer oder mehrerer Rollen 660 (Transportrollen).

Gemäß verschiedenen Ausführungsformen kann in der Bestrahlungskammer 600 ein Vakuum im Bereich des Grobvakuums, des Feinvakuums, des Hochvakuums oder des Ultrahochvakuums bereitgestellt sein oder werden. Das Vakuum (oder allgemein Unterdruck) kann beispielsweise mittels einer Vakuumpumpenanordnung bereitgestellt sein oder werden (nicht dargestellt), wobei die Vakuumpumpenanordnung beispielsweise eine Vorvakuumpumpe (z.B. eine Wälzkolbenpumpe, Membranpumpe oder Drehschieberpumpe) und/oder eine Hochvakuumpumpe (z.B. Turbomolekularpumpe) aufweisen kann. Ein jeweiliger Prozessdruck kann innerhalb der Bestrahlungskammer 600 dynamisch bereitgestellt sein oder werden, wobei während des Prozessierens sowohl mindestens ein Gas (z.B. Prozessgase, Reaktivgas, oder Inertgas) in die Bestrahlungskammer 600 eingeleitet wird, als auch das eingeleitete Gas wieder aus der Bestrahlungskammer 600 mittels der Vakuumpumpenanordnung abgepumpt wird. Dabei kann sich ein Gleichgewicht einstellen, wodurch der Prozessdruck (z.B. ein Druck des Prozessgases) festgelegt werden kann. Der Gasfluss durch die Bestrahlungskammer 600 hindurch und/oder der Prozessdruck kann dabei mittels Ventilen und/oder Sensoren (einer Regelung) geregelt und/oder gesteuert werden.

Alternativ kann die Bestrahlungskammer 600 (bzw. die Prozesskammeranordnung 200) bei Atmosphärendruck betrieben werden, z.B. bei Normaldruck (bzw. bei dem jeweils außerhalb der Bestrahlungskammer 600 herrschenden Luftdruck) oder bei leichtem Überdruck (z.B. bei ungefähr 1 hPa bis ungefähr 100 hPa über dem jeweils außerhalb der Bestrahlungskammer 600 herrschenden Luftdruck) sein. Ferner kann die Bestrahlungskammer 600 bei Überdruck betrieben werden, wobei Substrate bei einem Druck von mehr als 1200 hPa prozessiert werden können, z.B. in einem Prozessgas. Dazu kann die Bestrahlungskammer 600 oder die Prozesskammeranordnung 200 entsprechend angepasst sein, um die Druckbedingungen realisieren zu können.

Die räumliche Ausdehnung der Bestrahlungskammer 600 entlang der Richtung 201 (z.B. entlang einer Substrat-Transportrichtung) kann in einem Bereich von ungefähr 20 cm bis ungefähr 600 cm liegen, z.B. in einem Bereich von ungefähr 40 cm bis ungefähr 100 cm. Ferner kann die Breite (z.B. die räumliche Ausdehnung entlang der Richtung 203 quer zur Transportrichtung 201) der Bestrahlungskammer 600 in einem Bereich von ungefähr 20 cm bis ungefähr 600 cm liegen, z.B. in einem Bereich von ungefähr 100 cm bis ungefähr 450 cm (dabei muss die Breite jedoch mindestens größer sein als die Länge der mindestens einen Blitzlampe 204 in die gleiche Richtung).

Gemäß verschiedenen Ausführungsformen kann eine Prozesskammeranordnung 200 mit mehreren Prozesskammern eine Länge entlang der Transportrichtung 201 von mehr als 10 m aufweisen, z.B. von mehr als 20 m, z.B. von mehr als 30 m, z.B. von mehr als 40 m, z.B. von mehr als 50 m, z.B. von mehr als 60 m, z.B. von mehr als 70 m, z.B. von mehr als 80 m, z.B. von mehr als 90 m, z.B. von mehr als 100 m.

Gemäß verschiedenen Ausführungsformen kann die Prozesskammeranordnung 200 bzw. die Bestrahlungskammer 600 derart eingerichtet sein, dass diese lichtdicht ist oder lichtdicht betrieben werden kann, so dass beispielsweise beim Blitzen keine elektromagnetische Strahlung (z.B. UV-Licht) aus der Bestrahlungskammer 600 austreten kann. Die die Bestrahlungskammer 600 oder zumindest das Blitzlampenmodul 600a kann beispielsweise Teil einer Vakuumbeschichtungsanlage sein, z.B. Teil einer Glas-, Metallband- oder Folienbeschichtungsanlage.

Ferner kann die Prozesskammerabdeck-Anordnung 100 oder die Prozesskammer 200p Reflektoren aufweisen, derart eingerichtet, dass diese die in den Gasentladungslampen entstehende hochenergetische Lichtstrahlung auf das zu behandelnde Substrat 220 möglichst wirksam reflektieren (konzentrieren). Anschaulich kann mittels der Reflektoren, wie vorangehend beschrieben (vgl. Fig.2A), eine möglichst homogene räumliche Strahlungsverteilung bezogen auf die zu bestrahlende Fläche des Substrats 220 bereitzustellen.

Wie beispielsweise in Fig.6A und Fig.6B veranschaulicht ist, können mindestens zwei Seitenreflektoren 206a, 206b in dem Kammergehäuse 600b (bzw. in der Bestrahlungskammer 600) derart angerordnet sein, dass die mindestens zwei Seitenreflektoren 206a, 206b den Bestrahlungsbereich 210 entlang der Transportrichtung 201 begrenzen. Die Transportrichtung 201 kann sich beispielsweise aus der Lage der Transportrollen 660 in dem Kammergehäuse 600b (bzw. in der Bestrahlungskammer 600) ergeben und senkrecht zu den Rollenachsen (d.h. senkrecht zu den Drehachsen der Transportrollen 660) gerichtet sein.

Wie vorangehend beschrieben ist, kann zwischen dem zu bestrahlenden Substrat und dem jeweiligen Seitenreflektor 206a, 206b (gemessen von der zu bestrahlenden Oberfläche 620a des Substrats 220 bis zur Unterkante des jeweiligen Seitenreflektors 206a, 206b) ein Spalt mit der Spalthöhe 205h bereitgestellt sein oder werden. Wenn sich beispielsweise kein Substrat 220 in dem Kammergehäuse 600b (bzw. in der Bestrahlungskammer 600) befindet kann sich der Spalt zwischen dem jeweiligen Seitenreflektor 206a, 206b und der Transportebene 601 e erstrecken, z.B. gemessen von der Transportebene 601e bis zur Unterkante des jeweiligen Seitenreflektors 206a, 206b).

Die Seitenreflektoren 206a, 206b können sich beispielsweise plattenförmig in einer Ebene senkrecht zur Transportrichtung 201 erstrecken. Die Seitenreflektoren 206a, 206b können mindestens eine spiegelnde (elektromagnetische Strahlung reflektierende) Oberfläche aufweisen, welche zum Bestrahlungsbereich hin frei liegt. Dabei können die Seitenreflektoren 206a, 206b als Blendenstruktur verstanden werden, welche den Bestrahlungsbereich 210 in welchem das Substrat 220 abschnittsweise bestrahlt werden soll, begrenzt.

Gemäß verschiedenen Ausführungsformen können die Reflektoren (z.B. die beiden Seitenreflektoren 206a, 206b) auf der den Gasentladungslampen 204 zugewandten Oberfläche hochreflektierend und wassergekühlt sein. Ferner kann zumindest ein Reflektor vom Substrat aus betrachtet hinter dem Lampenfeld angeordnet sein (ein so genannter Rück- oder Deckelreflektor). Ferner können weitere Seitenreflektoren seitlich des Lampenfeldes angeordnet sein, z.B. im den Bestrahlungsbereich 210 in Richtung 203 (quer zu den Richtungen 201, 205) zu begrenzen.

Gemäß verschiedenen Ausführungsformen kann der Deckelreflektor zwischen den Blitzlampen 204 und dem Kammerdeckel 602 bereitgestellt sein, wobei der Deckelreflektor an dem Kammerdeckel 602 montiert sein kann.

Ferner kann der Deckelreflektor unabhängig von dem Kammerdeckel 602 in der Bestrahlungskammer 600 bereitgestellt sein.

Gemäß verschiedenen Ausführungsformen können die Seitenreflektoren 206a, 206b zwischen den Blitzlampen 204 den seitlichen Kammerwänden 600w bereitgestellt sein, wobei die Seitenreflektoren 206a, 206b an dem Kammergehäuse befestigt sein können. Alternativ können die Seitenreflektoren 206a, 206b an dem Kammerdeckel 602 montiert sein kann.

Es versteht sich, dass die Reflektoren bzw. die Blendenstruktur in verschiedenen gleichwirkenden Weisen bereitgestellt werden können, mit dem Ziel der optimalen Bestrahlung des Teils des Substrats 220, welcher in dem Bestrahlungsbereich 210 zu den Blitzlampen hin freiliegt.

Wie beispielsweise in Fig.6A und Fig.6B veranschaulicht ist, kann die Prozesskammeranordnung 200 mindestens eine Prozesskammer 600 (bezeichnet als Bestrahlungskammer 600) aufweisen und eine mit der Prozesskammer 600 gekoppelte Blitzlampenanordnung 200a zum Bestrahlen eines Substrats 220 innerhalb eines Bestrahlungsbereichs 210 in der Prozesskammer 600. Ferner kann die Prozesskammeranordnung 200 ein Transportsystem 660 aufweisen zum Transportieren des zu bestrahlenden Substrats 220 durch den Bestrahlungsbereich 210 hindurch, wobei das Transportsystem 660 eine Transportebene 601 e und eine Transportrichtung 201 definiert und eine Blendenstruktur 206a, 206 (auch bezeichnet als Seitenreflektoren 206a, 206), welche den Bestrahlungsbereich 210 entlang der Transportrichtung 201 begrenzt. Dabei kann zwischen der Transportebene 601 e und der Blendenstruktur 206a, 206b ein Spalt bereitgestellt sein, wobei der Spalt eine Spalthöhe 605h von weniger als 5 cm aufweist.

Gemäß verschiedenen Ausführungsformen können die Bereiche der Transportrollen, auf welchen jeweils das zu transportierende Substrat 220 aufliegt, in der Transportebene 601e liegen bzw. die Transportebene 601 e definieren.

Analog zum vorangehend Beschriebenen kann die Blendenstruktur 206a, 206b derart eingerichtet sein, dass diese den Bestrahlungsbereich 210 entlang der Transportrichtung 201 auf eine Bestrahlungsbereichslänge, L, begrenzt; wobei das Transportsystem eine Steuerung oder Regelung derart aufweist, dass das Substrat 220 mit einer Transportgeschwindigkeit, V, transportiert wird; und wobei die Blitzlampenanordnung 200a eine Steuerung oder Regelung derart aufweist, dass ein zeitlicher Abstand zwischen einem ersten Bestrahlen des Substrats und einem erneuten Bestrahlen des Substrats größer ist als L/2V, so dass mindestens ein erster Bereich des Substrats 220 genau einmal bestrahlt wird, und kleiner ist als L/V, so dass mindestens ein zweiter Bereich des Substrats 220 genau zweimal bestrahlt wird.

Anschaulich würde im Betrieb mit einer Blitzfrequenz von mehr als 2V/L jeder Bereich des Substrats 220 mindestens dreimal bestrahlt werden, was beispielsweise zu einer zu großen thermischen Belastung des Substrats 220 oder der Beschichtung des Substrats während des Prozessierens führen kann und/oder wodurch unkontrollierte Veränderungen (z.B. Diffusion oder Ähnliches) in dem Substrat oder in der Beschichtung des Substrats angeregt werden könnten.

In Fig.7 ist eine Prozesskammeranordnung 200 mit einer Bestrahlungskammer 600 veranschaulicht, wie vorangehend beschrieben ist, wobei die Bestrahlungskammer 600 nicht aus einem separaten Kammergehäuse 600a und Kammerdeckel 600b zusammengesetzt ist, sondern im Wesentlichen eine einstückige Prozesskammer 700k aufweist.

In den seitlichen Kammerwänden 600w des Kammergehäuses 600b oder der Prozesskammer 700k können Substrattransferöffnungen bereitgestellt sein oder werden, durch welche das Substrat 220 hindurch transportiert werden kann. Die Blitzlampenanordnung 200a kann eine Halterung 702h aufweisen und derart in und/oder an der Prozesskammer 700k bereitgestellt sein, dass das Substrat 220 in dem Bestrahlungsbereich 210 bestrahlt werden kann.

Gemäß verschiedenen Ausführungsformen kann die Blitzlampenanordnung 200a mit den jeweiligen Reflektoren als eine Strahlungsquelle angesehen werden, welche, wie vorangehend beschrieben, elektromagnetischen Strahlung zeitlich gepulst mit einer entsprechend von den Eigenschaften und der relativen Anordnung der Blitzlampen 204 und der jeweiligen Reflektoren abhängigen räumlichen Verteilung emittiert. Dabei ist die räumliche Verteilung im Wesentlichen in einer Ebene parallel zur Transportebene 601 e relevant für das flächig homogene Bestrahlen des Substrats 220.

Gemäß verschiedenen Ausführungsformen kann die räumlichen Verteilung der emittierten Strahlung mittels Testsubstraten ermittelt werden oder mittels eines entsprechenden Strahlungssensors oder einer entsprechenden Strahlungssensoranordnung. Anschaulich kann die räumliche Verteilung der emittierten Strahlung der räumlichen Verteilung der Bestrahlung, H, auf dem Substrat 220 entsprechen. Die räumliche Verteilung der emittierten Strahlung kann mittels verschiedener radiometrischer Größen oder physikalischer Größen (wie z.B. Leistungsdichte, Flächenleistungsdichte, Energiedichte) beschrieben werden. Auch der zeitliche Verlauf der gepulst emittierten Strahlung kann mittels verschiedener radiometrischer Größen oder physikalischer Größen (wie z.B. Leistungsdichte, Flächenleistungsdichte, Energiedichte) beschrieben werden. Die räumlich Verteilung und der zeitliche Verlauf der emittierten Strahlung kann beispielsweise mit derselben radiometrischen Größe oder physikalischen Größe (z.B. Intensität oder der Bestrahlung oder der Strahldichte) beschrieben werden.

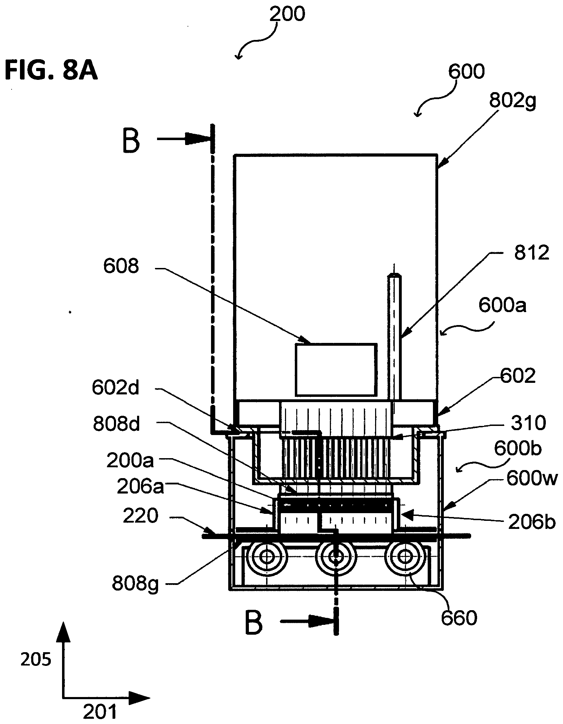

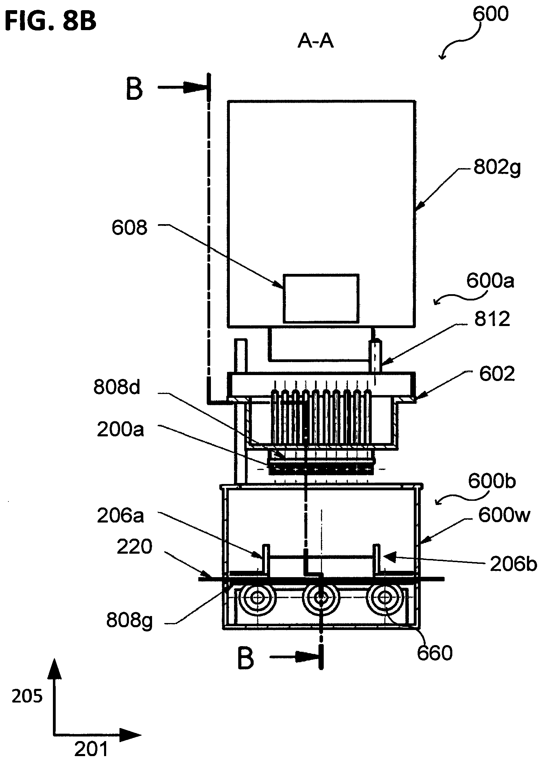

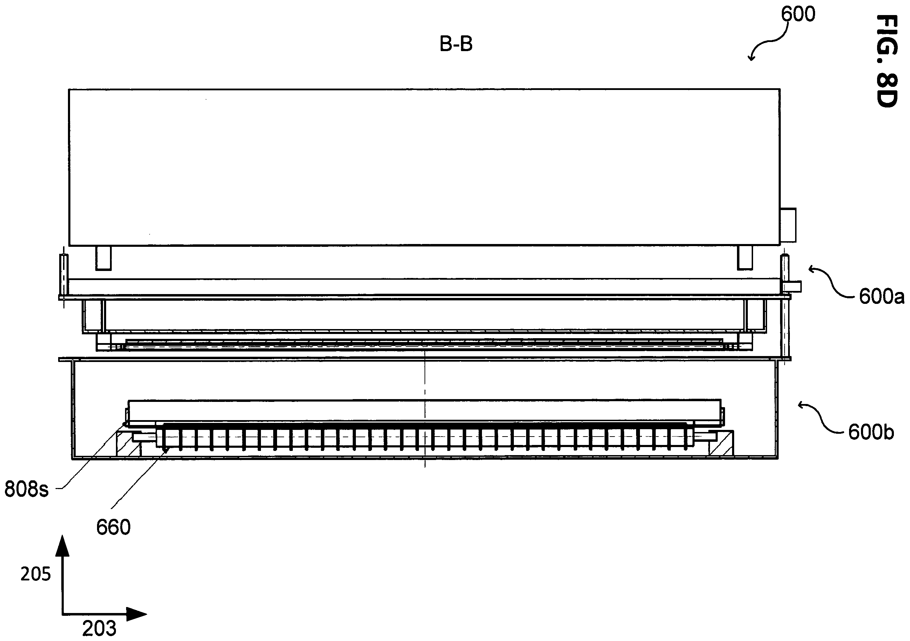

**Fig.8A** veranschaulicht eine Prozesskammeranordnung 200 in einer schematischen Seitenansicht oder Querschnittsansicht, gemäß verschiedenen Ausführungsformen, wobei die Prozesskammeranordnung 200 ein Kammergehäuse 600b aufweist, auf welches ein Blitzlampenmodul 600a aufgesetzt ist, wie vorangehend beschrieben. Ferner veranschaulicht ist die Prozesskammeranordnung 200 in geöffnetem Zustand in **Fig.8B** veranschaulicht, wobei in **Fig.8D** eine entsprechende Schnittansicht entlang des Schnittes B-B dargestellt ist.

Gemäß verschiedenen Ausführungsformen kann die Prozesskammeranordnung 200 bzw. die Bestrahlungskammer 600 der Prozesskammeranordnung 200 mehrere Reflektoren oder Reflektor-Strukturen aufweisen, z.B. einen Stirnseiten-Reflektor 808s (vgl. Fig.8D, einen Seitenreflektor 206a, 206b oder mehrere Seitenreflektoren 206a, 206b, einen Deckelreflektor 808d, und einen Gegenreflektor 808g. Der Gegenreflektor 808g kann beispielsweise flächig unterhalb der Transportebene angeordnet sein und sich im Wesentlichen parallel zur Transportebene erstrecken. Gemäß verschiedenen Ausführungsformen kann die Bestrahlungskammer 600 derart eingerichtet sein, dass das Substrat 220 zwischen den Transportrollen 660 und der Blitzlampenanordnung 200a bzw. auf den Transportrollen 660 zwischen dem Gegenreflektor 808g und der Blitzlampenanordnung 200a transportiert werden kann. Dabei können sich Abschnitte der Transportrollen 660 durch den Gegenreflektor 808g hindurch erstrecken, z.B. kann jede der Transportrollen 660 scheibenförmige (ringförmig umlaufende) Bereiche aufweisen, auf welchen das Substrat 220 beim Transport aufliegt, wobei sich die scheibenförmigen Bereiche durch den Gegenreflektor 808g hindurch erstrecken können, so dass das Substrat oberhalb des Gegenreflektors 808g transportiert werden kann, wobei die Transportrollen unterhalb des Gegenreflektors 808g gelagert sind.

Ferner kann die Versorgungsvorrichtung auf dem Kammerdeckel 602 von einem Deckelgehäuse 802g umgeben werden.

Das Montieren und Demontieren der Prozesskammer-Anordnung 200 kann unter Verwendung einer Zentriervorrichtung 812 erfolgen, wobei sich die Zentriervorrichtung 812 im montierten Zustand der Prozesskammeranordnung 200 beispielsweise durch entsprechend passende Durchgangslöcher in dem Kammerdeckel 602 oder durch entsprechend passende Durchgangslöcher in dem Blitzlampenmodul 600a hindurch erstrecken kann.

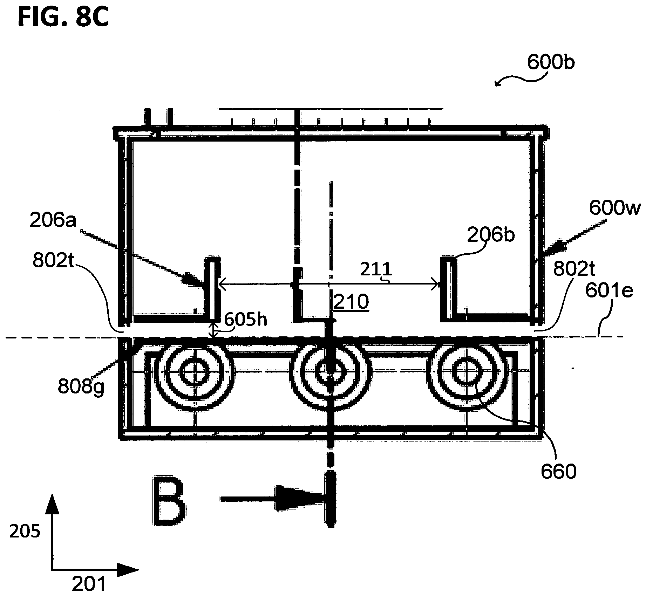

**Fig.8C** veranschaulicht eine Detailansicht des Kammergehäuses 600b der Bestrahlungskammer 600 der Prozesskammeranordnung 200 (vgl. Fig.8B), gemäß verschiedenen Ausführungsformen. Wie vorangehend beschrieben kann mittels der Seitenreflektoren 206a, 206b der Bestrahlungsbereich 210 auf die Bestrahlungsbereichslänge 211 gemessen in Transportrichtung 201 begrenzt werden. Dabei kann für das Bestrahlen des Substrats 220 in dem Bestrahlungsbereich der Abstand 605h zwischen der Transportebene 601 e und dem jeweiligen Seitenreflektor 206a, 206b wesentlich sein, wie vorangehend beschrieben ist. Gemäß verschiedenen Ausführungsformen kann der Abstand 605h zwischen der Transportebene 601 e und dem jeweiligen Seitenreflektor 206a, 206b geringer sein als 5 cm. Ferner kann der Abstand 605h zwischen der Transportebene 601 e und dem jeweiligen Seitenreflektor 206a, 206b geringer sein als d + 22 mm, wobei d die Substratdicke (gemessen in eine Richtung senkrecht zur Transportebene, z.B. in Richtung 205) des zu bestrahlenden Substrats 220 ist. Anschaulich können die Seitenreflektoren 206a, 206b derart in dem Kammergehäuse 600b der Bestrahlungskammer 600 bereitgestellt sein oder werden, dass zwischen dem mittels der Transportrollen 660 transportieren Substrat 220 und dem jeweiligen Seitenreflektor 206a, 206b ein Spalt 212 mit einer Spalthöhe 205h von weniger als 22 mm verleibt (vgl. Fig.2A).

Gemäß verschiedenen Ausführungsformen kann die Spalthöhe 205h des Spalts 212 zwischen dem mittels der Transportrollen 660 transportieren Substrat 220 und dem jeweiligen Seitenreflektor 206a, 206b sowie der Abstand 605h zwischen der Transportebene 601 e und dem jeweiligen Seitenreflektor 206a, 206b an das zu bestrahlende Material angepasst sein oder werden.

Gemäß verschiedenen Ausführungsformen können die Seitenreflektoren 206a, 206b verschiebbar oder frei positionierbar eingerichtet sein, so dass die Spalthöhe 205h des Spalts 212 zwischen dem mittels der Transportrollen 660 transportieren Substrat 220 und dem jeweiligen Seitenreflektor 206a, 206b sowie der Abstand 605h zwischen der Transportebene 601 e und dem jeweiligen Seitenreflektor 206a, 206b an das zu bestrahlende Material und/oder an die Substratdicke angepasst werden kann.

Ferner kann das Kammergehäuse 600b der Bestrahlungskammer 600 seitliche Kammerwände 600w oder Schottwände 600w aufweisen, in welche beispielsweise jeweils eine Substrattransferöffnung 802t bereitgestellt sein kann. Die Substrattransferöffnung 802t kann beispielsweise im Querschnitt geringfügig größer sein als der Querschnitt des zu bestrahlenden Substrats.

Ferner kann das Kammergehäuse 600b der Bestrahlungskammer 600, z.B. wenn die Bestrahlungskammer 600 als Vakuumkammer eingerichtet ist, eine oder mehrere Gasseparationsstrukturen aufweisen zum mindern eines Gasflusses entlang der Transportrichtung 201 durch das Kammergehäuse 600b hindurch.

Gemäß verschiedenen Ausführungsformen kann der Bestrahlungsbereich zwischen der Blitzlampenanordnung und dem zu bestrahlenden Substrat beispielsweise frei von einer Maskenstruktur sein, welche beim Bestrahlen auf das zu bestrahlende Substrat abgebildet wird. Somit kann die Blendenstruktur lediglich die äußeren Grenzen (z.B. die Umrandung) des Bestrahlungsbereichs definieren. Ferner kann das Bestrahlen bei bewegtem Substrat erfolgen.

## Patentansprüche

1. Verfahren (100) zum Bestrahlen eines Substrats (220) in einer Prozesskammer, das Verfahren (100) aufweisend:
• Transportieren des Substrats (220) entlang einer Transportrichtung (201) in einem Bestrahlungsbereich (210) in der Prozesskammer, wobei der Bestrahlungsbereich (210) mittels einer Blendenstruktur (206) auf eine Bestrahlungsbereichslänge (211) in Transportrichtung (201) begrenzt ist; wobei die Bestrahlungsbereichslänge (211) kleiner ist als eine Substratlänge (221) des Substrats (220) in Transportrichtung (201); und
• ein erstes Bestrahlen (215a) des Substrats (220) in dem Bestrahlungsbereich (210) und danach ein zweites Bestrahlen (215b) des Substrats (220) in dem Bestrahlungsbereich (210), während das Substrat (220) mit einer Transportgeschwindigkeit (V) transportiert wird, **dadurch gekennzeichnet, dass** der zeitliche Abstand (T) des ersten Bestrahlens (215a) und des zweiten Bestrahlens (215b) größer ist als der Quotient aus der halben Bestrahlungsbereichslänge (211) und der Transportgeschwindigkeit (V), so dass mindestens ein erster Bereich (220a, 220b) des Substrats (220) genau einmal bestrahlt wird, und wobei der zeitliche Abstand (T) des ersten Bestrahlens (215a) und des zweiten Bestrahlens (215b) kleiner ist als der Quotient aus der Bestrahlungsbereichslänge (211) und der Transportgeschwindigkeit (V), so dass mindestens ein zweiter Bereich (311) des Substrats (220) genau zweimal bestrahlt wird.

2. Verfahren gemäß Anspruch 1,
• wobei das erste Bestrahlen (215a) und das zweite Bestrahlen (215b) des Substrats (220) in dem Bestrahlungsbereich (215) mittels jeweils mindestens eines Strahlungspulses erfolgen, wobei der jeweils mindestens eine Strahlungspuls in dem Bestrahlungsbereich (210) eine räumliche Strahlungsverteilung (315) entlang der Transportrichtung (201) aufweist.

3. Verfahren gemäß Anspruch 2,
wobei das erste Bestrahlen (215a) und das zweite Bestrahlen (215b) unter Verwendung einer Blitzlampenanordnung (200a) erfolgen, wobei die Blitzlampenanordnung (200a) mindestens eine Gasentladungsröhre (204) aufweist, wobei sich die mindestens eine Gasentladungsröhre (204) quer zur Transportrichtung (201) erstreckt.

4. Verfahren gemäß Anspruch 2 oder 3,
wobei die räumliche Strahlungsverteilung ein Maximum und eine räumliche Halbwertsbreite (HWB) aufweist, wobei der zeitliche Abstand (T) des ersten Bestrahlens (215a) und des zweiten Bestrahlens (215b) ungefähr gleich dem Quotienten aus der Halbwertsbreite (HWB) und der Transportgeschwindigkeit (V) ist.

5. Verfahren gemäß Anspruch 2 oder 3,
wobei die räumliche Strahlungsverteilung ein Maximum und eine räumliche Halbwertsbreite (HWB) aufweist, wobei der zeitliche Abstand (T) des ersten Bestrahlens (215a) und des zweiten Bestrahlens (215b) kleiner ist als der Quotient aus der Halbwertsbreite (HWB) und der Transportgeschwindigkeit (V).

6. Verfahren gemäß Anspruch 2 oder 3,
wobei die räumliche Strahlungsverteilung ein Maximum aufweist, und wobei die räumliche Strahlungsverteilung Randbereiche aufweist, in denen die Strahlung geringer ist als 90% des Maximums, und wobei die räumliche Strahlungsverteilung einen Plateaubereich zwischen den Randbereichen mit einer Plateaulänge (L_{P}) aufweist, in dem die Strahlung größer ist als 90% des Maximums;
wobei der zeitliche Abstand (T) des ersten Bestrahlens (215a) und des zweiten Bestrahlens (215b) ungefähr gleich dem Quotienten aus der Plateaulänge (L_{P}) und der Transportgeschwindigkeit (V) ist.

7. Verfahren gemäß Anspruch 2 oder 3,
wobei die räumliche Strahlungsverteilung ein Maximum aufweist, und wobei die räumliche Strahlungsverteilung Randbereiche aufweist, in denen die Strahlung geringer ist als 10% des Maximums, und wobei die räumliche Strahlungsverteilung eine effektive Bestrahlungsbereichslänge (L_{E}) zwischen den Randbereichen aufweist, in dem die Strahlung größer ist als 10% des Maximums;
wobei der zeitliche Abstand (T) des ersten Bestrahlens (215a) und des zweiten Bestrahlens (215b) ungefähr gleich dem Quotienten aus der effektiven Bestrahlungsbereichslänge (L_{E}) und der Transportgeschwindigkeit (V) ist.

8. Verfahren gemäß Anspruch 2 oder 3,
wobei die räumliche Strahlungsverteilung ein Maximum aufweist, und wobei die räumliche Strahlungsverteilung Randbereiche aufweist, in denen die Strahlung geringer ist als 10% des Maximums, und wobei die räumliche Strahlungsverteilung eine effektive Bestrahlungsbereichslänge (L_{E}) zwischen den Randbereichen aufweist, in dem die Strahlung größer ist als 10% des Maximums;
wobei der zeitliche Abstand (T) des ersten Bestrahlens (215a) und des zweiten Bestrahlens (215b) kleiner ist als der Quotient aus der effektiven Bestrahlungsbereichslänge (L_{E}) und der Transportgeschwindigkeit (V).

9. Verfahren gemäß einem der Ansprüche 1 bis 8,
wobei zwischen dem Substrat (220) und der Blendenstruktur (206a, 206b) ein Spalt (212) bereitgestellt ist, wobei der Spalt (212) eine Spalthöhe (215h) von weniger als 40 mm aufweist.

10. Verfahren gemäß einem der Ansprüche 1 bis 9,
wobei die Transportgeschwindigkeit (V) in einem Bereich von 0,5 m/min bis ungefähr 30 m/min liegt.

11. Verfahren gemäß einem der Ansprüche 1 bis 10,
wobei die Bestrahlungsbereichslänge (211) in einem Bereich von 0,3 m bis ungefähr 6 m liegt.

12. Verfahren gemäß einem der Ansprüche 1 bis 11,
wobei das erste Bestrahlen (215a) und das zweite Bestrahlen (215b) jeweils eine Bestrahlungsdauer von weniger als 1 s aufweist.

13. Verfahren gemäß einem der Ansprüche 1 bis 12,
wobei das erste Bestrahlen (215a) und das zweite Bestrahlen (215b) derart bereitgestellt sind, dass der mindestens eine erste Bereich (220a, 220b) und der mindestens eine zweite Bereich (311) des Substrats (220) mit einer Bestrahlung in einem Bereich von ungefähr 1 J/cm² bis ungefähr 25 J/cm² bestrahlt werden.

14. Prozesskammeranordnung (200), aufweisend:
• mindestens eine Prozesskammer (600, 700k);
• eine mit der Prozesskammer (600, 700k) gekoppelte Blitzlampenanordnung (200a) zum Bestrahlen eines Substrats (220) innerhalb eines Bestrahlungsbereichs (210) in der Prozesskammer (600);
• ein Transportsystem zum Transportieren eines zu bestrahlenden Substrats (220) durch den Bestrahlungsbereich (210) hindurch, wobei das Transportsystem eine Transportebene (601 e) und eine Transportrichtung (201) definiert;
• eine Blendenstruktur (206a, 206b), welche den Bestrahlungsbereich (210) entlang der Transportrichtung (210) begrenzt;
• wobei zwischen der Transportebene (601e) und der Blendenstruktur (206a, 206b) ein Spalt (212) bereitgestellt ist, wobei der Spalt (212) eine Spalthöhe (205h) von weniger als 6 cm aufweist; wobei die Blendenstruktur (206a, 206b) derart eingerichtet ist, dass diese den Bestrahlungsbereich (210) entlang der Transportrichtung (201) auf eine Bestrahlungsbereichslänge (211) begrenzt;
• wobei das Transportsystem eine Steuerung oder Regelung derart aufweist, dass das Substrat (220) mit einer Transportgeschwindigkeit (V) transportiert wird; **dadurch gekennzeichnet, dass**
• die Blitzlampenanordnung (200a) eine Steuerung oder Regelung derart aufweist, dass ein zeitlicher Abstand zwischen einem ersten Bestrahlen (215a) des Substrats (220) und einem erneuten Bestrahlen (215b) des Substrats (220) größer ist als der Quotient aus der halben Bestrahlungsbereichslänge (211) und der Transportgeschwindigkeit (V), so dass mindestens ein erster Bereich (220a, 220b) des Substrats (220) genau einmal bestrahlt wird, und kleiner ist als der Quotient aus der Bestrahlungsbereichslänge (211) und der Transportgeschwindigkeit (V), so dass mindestens ein zweiter Bereich (311) des Substrats (220) genau zweimal bestrahlt wird.

## Claims

1. Method (100) for irradiating a substrate (220) in a process chamber, the method (100) comprising:
• transporting the substrate (220) in a transport direction (201) in an irradiation zone (210) in the process chamber, the irradiation zone (210) being limited to an irradiation zone length (211) in the transport direction (201) by a screen structure (206); the irradiation zone length (211) being less than a substrate length (221) of the substrate (220) in the transport direction (201); and
• a first irradiation (215a) of the substrate (220) in the irradiation zone (210) and subsequently a second irradiation (215b) of the substrate (220) in the irradiation zone (210), while the substrate is transported at a transport speed (V), **characterised in that** the time interval (T) between the first irradiation (215a) and the second irradiation (215b) is greater than the quotient of half the irradiation zone length (211) and the transport speed (V), such that at least one first zone (220a, 220b) of the substrate (220) is irradiated precisely once, and the time interval (T) between the first irradiation (215a) and the second irradiation (215b) is less than the quotient of the irradiation zone length (211) and the transport speed (V), such that at least one second zone (311) of the substrate (220) is irradiated precisely twice.

2. Method according to claim 1,
• wherein the first irradiation (215a) and the second irradiation (215b) of the substrate (220) in the irradiation zone (215) are carried out by means of at least one radiation pulse in each case, wherein the at least one radiation pulse in each case has a spatial radiation distribution (315) in the transport direction (201) in the irradiation zone (210).

3. Method according to claim 2,
wherein the first irradiation (215a) and the second irradiation (215b) are carried out using a flashlamp arrangement (200a), wherein the flashlamp arrangement (200a) comprises at least one gas-discharge tube (204), wherein the at least one gas-discharge tube (204) extends transversely to the transport direction (201).

4. Method according to either claim 2 or claim 3,
wherein the spatial radiation distribution has a maximum and a spatial full width at half maximum (HWB), wherein the time interval (T) between the first irradiation (215a) and the second irradiation (215b) is approximately equal to the quotient of the full width at half maximum (HWB) and the transport speed (V).

5. Method according to either claim 2 or claim 3,
wherein the spatial radiation distribution has a maximum and a spatial full width at half maximum (HWB), wherein the time interval (T) between the first irradiation (215a) and the second irradiation (215b) is less than the quotient of the full width at half maximum (HWB) and the transport speed (V).

6. Method according to either claim 2 or claim 3,
wherein the spatial radiation distribution has a maximum, and wherein the spatial radiation distribution has peripheral zones in which the radiation is less than 90 % of the maximum, and wherein the spatial radiation distribution has a plateau zone between the peripheral zones that has a plateau length (L_{P}) and in which the radiation is greater than 90 % of the maximum;
wherein the time interval (T) between the first irradiation (215a) and the second irradiation (215b) is approximately equal to the quotient of the plateau length (L_{P}) and the transport speed (V).

7. Method according to either claim 2 or claim 3,
wherein the spatial radiation distribution has a maximum, and wherein the spatial radiation distribution has peripheral zones in which the radiation is less than 10 % of the maximum, and wherein the spatial radiation distribution has an effective irradiation zone length (L_{E}) between the peripheral zones in which the radiation is greater than 10 % of the maximum; wherein the time interval (T) between the first irradiation (215a) and the second irradiation (215b) is approximately equal to the quotient of the effective irradiation zone length (L_{E}) and the transport speed (V).

8. Method according to either claim 2 or claim 3,
wherein the spatial radiation distribution has a maximum, and wherein the spatial radiation distribution has peripheral zones in which the radiation is less than 10 % of the maximum, and wherein the spatial radiation distribution has an effective irradiation zone length (L_{E}) between the peripheral zones in which the radiation is greater than 10 % of the maximum;
wherein the time interval (T) between the first irradiation (215a) and the second irradiation (215b) is less than the quotient of the effective irradiation zone length (L_{E}) and the transport speed (V).

9. Method according to any one of claims 1 to 8,
wherein a gap (212) is provided between the substrate (220) and the screen structure (206a, 206b), wherein the gap (212) has a gap height (215h) of less than 40 mm.

10. Method according to any one of claims 1 to 9,
wherein the transport speed (V) is within a range of from 0.5 m/min to approximately 30 m/min.

11. Method according to any one of claims 1 to 10,
wherein the irradiation zone length (211) is within a range of from 0.3 m to approximately 6 m.

12. Method according to any one of claims 1 to 11,
wherein the first irradiation (215a) and the second irradiation (215b) each have an irradiation duration of less than 1 s.

13. Method according to any one of claims 1 to 12,
wherein the first irradiation (215a) and the second irradiation (215b) are provided such that the at least one first zone (220a, 220b) and the at least one second zone (311) of the substrate (220) are irradiated with irradiation within a range of from approximately 1 J/cm² to approximately 25 J/cm².

14. Process chamber arrangement (200), comprising:
• at least one process chamber (600, 700k);
• a flashlamp arrangement (200a) coupled to the process chamber (600, 700k) for irradiating a substrate (220) within an irradiation zone (210) in the process chamber (600);
• a transport system for transporting a substrate (220) to be irradiated through the irradiation zone (210), the transport system defining a transport plane (601 e) and a transport direction (201);
• a screen structure (206a, 206b) which defines the irradiation zone (210) in the transport direction (210);
• a gap (212) being provided between the transport plane (601 e) and the screen structure (206a, 206b), the gap (212) having a gap height (205h) of less than 6 cm; the screen structure (206a, 206b) being designed such that it limits the irradiation zone (210) to an irradiation zone length (211) in the transport direction (201);
• the transport system being controlled such that the substrate (220) is transported at a transport speed (V);
**characterised in that**
• the flashlamp arrangement (200a) being controlled such that a time interval between a first irradiation (215a) of the substrate (220) and another irradiation (215b) of the substrate (220) is greater than the quotient of half the irradiation zone length (211) and the transport speed (V), such that at least one first zone (220a, 220b) of the substrate (220) is irradiated precisely once, and is less than the quotient of the irradiation zone length (211) and the transport speed (V), such that at least one second zone (311) of the substrate (220) is irradiated precisely twice.

## Revendications

1. Procédé (100) pour l'irradiation d'un substrat (220) dans une chambre de traitement, le procédé (100) comprenant :
• le transport du substrat (220) le long d'une direction de transport (201) dans une zone d'irradiation (210) de la chambre de traitement, la zone d'irradiation (210) étant limitée par une structure à diaphragme (206) à une longueur de zone d'irradiation (211) dans la direction de transport (201) ; la longueur de la zone d'irradiation (211) étant inférieure à une longueur de substrat (221) du substrat (220) dans la direction de transport ; et
• une première irradiation (215a) du substrat (220) dans la zone d'irradiation (210) puis une deuxième irradiation (215b) du substrat (220) dans la zone d'irradiation (210), tandis que le substrat (220) est transporté avec une vitesse de transport (V),
**caractérisé en ce que** l'intervalle temporel (T) entre la première irradiation (215a) et la deuxième irradiation (215b) est supérieur au quotient entre la moitié de la longueur d'irradiation (211) et la vitesse de transport (V), de façon à ce qu'au moins une première zone (220a, 220b) du substrat (220) soit irradiée exactement une fois et l'intervalle temporel (T) entre la première irradiation (215a) et la deuxième irradiation (215b) étant inférieur au quotient entre la longueur d'irradiation (211) et la vitesse de transport (V), de façon à ce qu'au moins une deuxième zone (311) du substrat (220) soit irradiée exactement deux fois.

2. Procédé selon la revendication 1, dans lequel
• la première irradiation (215a) et la deuxième irradiation (215b) du substrat (220) dans la zone d'irradiation (215) ont lieu chacune au moyen d'au moins une impulsion de rayonnement, l'au moins une impulsion de rayonnement présentant, dans la zone d'irradiation (210), une distribution spatiale du rayonnement (315) le long de la direction de transport (201).

3. Procédé selon la revendication 2, dans lequel
la première irradiation (215a) et la deuxième irradiation (215b) ont lieu à l'aide d'un dispositif à flash (200a), le dispositif à flash (200a) comprenant au moins un tube à décharge de gaz (204), l'au moins un tube à décharge de gaz (204) s'étendant transversalement par rapport à la direction de transport (201).

4. Procédé selon la revendication 2 ou 3,
la distribution spatiale du rayonnement présentant un maximum et une largeur à mi-hauteur (HWB), l'intervalle temporel (T) entre la première irradiation (215a) et la deuxième irradiation (215b) étant approximativement égal au quotient entre la largeur à mi-hauteur (HWB) et la vitesse de transport (V).

5. Procédé selon la revendication 2 ou 3,
la distribution spatiale du rayonnement présentant un maximum et une largeur à mi-hauteur (HWB), l'intervalle temporel (T) entre la première irradiation (215a) et la deuxième irradiation (215b) étant inférieur au quotient de la largeur à mi-hauteur (HWB) et de la vitesse de transport (V).

6. Procédé selon la revendication 2 ou 3,
la distribution spatiale du rayonnement présentant un maximum et la distribution spatiale du rayonnement présentant des zones de bord dans lesquelles le rayonnement est inférieur à 90 % du maximum et la distribution spatiale du rayonnement présentant une zone de plateau entre les zones de bord, avec une longueur de plateau (L_{P}), où le rayonnement est supérieur à 90 % du maximum ;
l'intervalle temporel (T) entre la première irradiation (215a) et la deuxième irradiation (215b) étant approximativement égal au quotient entre la longueur du plateau (L_{P}) et la vitesse de transport (V).

7. Procédé selon la revendication 2 ou 3, dans lequel
la distribution spatiale du rayonnement présentant un maximum et la distribution spatiale du rayonnement présentant des zones de bord dans lesquelles le rayonnement est inférieur à 10% du maximum et la distribution spatiale du rayonnement présentant une longueur efficace de zone d'irradiation (L_{E}) entre les zones de bord, où le rayonnement est supérieur à 10 % du maximum ;
l'intervalle temporel (T) entre la première irradiation (215a) et la deuxième irradiation (215b) étant approximativement égal au quotient entre la longueur efficace de zone d'irradiation (L_{E}) et la vitesse de transport (V).

8. Procédé selon la revendication 2 ou 3, dans lequel
la distribution spatiale du rayonnement présentant un maximum et la distribution spatiale du rayonnement présentant des zones de bord dans lesquelles le rayonnement est inférieur à 10% du maximum et la distribution spatiale du rayonnement présentant une longueur efficace de zone d'irradiation (L_{E}) entre les zones de bord, où le rayonnement est supérieur à 10% du maximum ;
l'intervalle temporel (T) entre la première irradiation (215a) et la deuxième irradiation (215b) étant inférieur au quotient entre la longueur efficace de zone d'irradiation (L_{E}) et la vitesse de transport (V).

9. Procédé selon l'une des revendications 1 à 8,
un interstice (212) étant réalisé entre le substrat (220) et la structure à diaphragme (206a, 206b), l'interstice (212) présentant une hauteur d'interstice (215h) inférieure à 40 mm.

10. Procédé selon l'une des revendications 1 à 9,
la vitesse de transport (V) se trouvant dans une plage de 0,5 m/min à environ 30 m/min.

11. Procédé selon l'une des revendications 1 à 10,
la longueur de zone d'irradiation (211) se trouvant dans une plage de 0,3 m à environ 6 m.

12. Procédé selon l'une des revendications 1 à 11,
la première irradiation (215a) et la deuxième irradiation (215b) présentant chacune une durée d'irradiation inférieure à 1 s.

13. Procédé selon l'une des revendications 1 à 12,
la première irradiation (215a) et la deuxième irradiation (215b) étant conçues de façon à ce qu'au moins une première zone (220a, 220b) et l'au moins une deuxième zone (311) du substrat (220) sont irradiées avec une irradiation dans une zone d'environ 1 J/cm² à environ 25 J/cm².

14. Disposition de chambre de traitement (200) comprenant :
• au moins une chambre de traitement (600, 700k) ;
• un dispositif à flash (200a) couplé avec la chambre de traitement (600, 700k) pour l'irradiation d'un substrat (220) à l'intérieur d'une zone d'irradiation (210) de la chambre de traitement (600) ;
• un système de transport pour le transport d'un substrat (220) à irradier à travers la zone d'irradiation (210), le système de transport définissant un plan de transport (601 e) et une direction de transport (201) ;
• une structure à diaphragme (206a, 206b) qui limite la zone d'irradiation (210) le long de la direction de transport (210) ;
• un interstice (212) étant réalisé entre le plan de transport (601e) et la structure de diaphragme (206a, 206b), l'interstice (212) présentant une hauteur d'interstice (205h) inférieure à 6 cm ; la structure à diaphragme (206a, 206b) étant conçue de façon à ce que celle-ci limite la zone d'irradiation (210) le long de la direction de transport (201) à une longueur de zone d'irradiation (211) ;
• le système de transport comprenant un dispositif de commande ou de régulation de façon à ce que le substrat (220) soit transporté avec une vitesse de transport (V) ;
**caractérisé en ce que**
• le dispositif à flash (200a) comprend un dispositif de commande ou de régulation de façon à ce qu'un intervalle temporel entre une première irradiation (215a) du substrat (220) et une nouvelle irradiation (215b) du substrat (220) est supérieur au quotient entre la moitié de la longueur de la zone d'irradiation (211) et la vitesse de transport (V), de façon à ce qu'au moins une première zone (220a, 220b) du substrat (220) soit irradiée exactement une fois, et inférieur au quotient entre la longueur de la zone d'irradiation (211) et la vitesse de transport (V), de façon à ce qu'au moins une deuxième zone (311) du substrat (220) soit irradiée exactement deux fois.
